# EUROPEAN PATENT APPLICATION

(11) **EP 4 583 522 A1**
(43) Date of publication of application: **09.07.2025**
(21) Application number: 24816897.3
(22) Date of filing: 22.10.2024
(51) Int. Cl.: H04N 23/57

(54) **CAMERA MODULE AND ELECTRONIC DEVICE COMPRISING SAME**

(30) Priority: 06.11.2023 KR 20230151789; 16.02.2024 KR 20240022710
(71) Applicant: SAMSUNG ELECTRONICS CO., LTD., Yeongtong-gu Suwon-si, Gyeonggi-do 16677 (KR)
(72) Inventor: JUNG, Hwajoong, Suwon-si, Gyeonggi-do 16677 (KR); KIM, Beomsik, Suwon-si, Gyeonggi-do 16677 (KR); KIM, Bongchan, Suwon-si, Gyeonggi-do 16677 (KR); KIM, Taehwan, Suwon-si, Gyeonggi-do 16677 (KR); BYON, Kwangseok, Suwon-si, Gyeonggi-do 16677 (KR); AN, Hyosang, Suwon-si, Gyeonggi-do 16677 (KR); PARK, Jaehyoung, Suwon-si, Gyeonggi-do 16677 (KR); WON, Jonghoon, Suwon-si, Gyeonggi-do 16677 (KR)
(74) Representative: HGF
(86) International application number: PCT/KR2024/016061
(87) International publication number: WO 2025/100786

(57) **Abstract**

A camera module according to an embodiment, may include a housing, a lens assembly disposed at least in part inside the housing, and including at least one lens, an image sensor for converting light received through the at least one lens into an electrical signal, a printed circuit board including a first side on which the lens assembly is disposed, a base on which the printed circuit board is disposed, and an electrical element connected to the printed circuit board. The printed circuit board may include a first region having a first thickness, and a second region having a second thickness which is greater than the first thickness. The first region may include a second side facing in a direction opposite to the first side. The electrical element may be disposed to the second side of the first region. Besides, various embodiments obtained from the specification are possible.

## Description

### [Technical Field]

Various embodiments disclosed in this document, relate to a camera module and an electronic device including the same.

### [Background Art]

With development of digital camera manufacturing technology, electronic devices with a small and lightweight camera module have been commercialized. As the camera module is mounted on the electronic device (e.g., a mobile communication terminal) which is generally portable, a user may easily utilize various functions such as video call or augmented reality, as well as image or video capturing.

An auto focus (AF) function is a function of an optical system which automatically adjust focus on a subject. The electronic device may move a lens (or a lens assembly) or an image sensor to focus on the subject.

An optic image stabilization (OIS) technology may be applied to improve quality of the captured image. The electronic device may detect movement of the electronic device using a motion sensor included in the electronic device. The electronic device may drive the lens or the image sensor to move in response to the movement of the electronic device, and thus acquire a stabilized image.

The foregoing information may be provided as related art for the purpose of aiding understanding of the disclosure. No claim or determination is made as to whether any of the foregoing may be applied as prior art in connection with the disclosure.

### [Disclosure of Invention]

### [Solution to Problem]

A camera module according to an embodiment, may include a housing, a lens assembly at least partially disposed in the housing, and including at least one lens, an image sensor for converting light received through the at least one lens into an electrical signal, a printed circuit board including a first side on which the lens assembly is disposed, a base on which the printed circuit board is disposed, and an electrical element connected to the printed circuit board. The printed circuit board may include a first region having a first thickness, and a second region having a second thickness which is greater than the first thickness. The first region may include a second side facing in a direction opposite to the first side. The electrical element may be disposed to the second side of the first region.

An electronic device according to an embodiment, may include a first plate, a second plate facing the first plate, a side member surrounding at least in part a space between the first plate and the second plate, and a camera module disposed inside the space. The camera module may include a housing, a lens assembly disposed at least in part inside the housing, and including at least one lens, an image sensor for converting light received through the at least one lens into an electrical signal, a printed circuit board including a first side on which the lens assembly is disposed, a base on which the printed circuit board is disposed, and an electrical element connected to the printed circuit board. The printed circuit board may include a first region having a first thickness, and a second region having a second thickness which is greater than the first thickness. The first region may include a second side facing in a direction opposite to the first side. The electrical element may be disposed to the second side of the first region.

### [Brief Description of Drawings]

FIG. 1 is a perspective view illustrating a front face of an electronic device according to an embodiment.
FIG. 2 is a perspective view of a rear face of an electronic device of FIG. 1.
FIG. 3 is a perspective view of a camera module according to an embodiment.
FIG. 4 is a diagram illustrating a camera module according to an embodiment.
FIG. 5 is a diagram illustrating a camera module disposed inside an electronic device according to an embodiment.
FIG. 6 is a diagram for illustrating a printed circuit board including a first region and a second region according to an embodiment.
FIG. 7 is a diagram for illustrating a first process and a second process of a manufacturing method of a printed circuit board according to an embodiment.
FIG. 8 is a diagram for illustrating a third process of a printed circuit board manufacturing method according to an embodiment.
FIG. 9 is a diagram for illustrating a fourth process of a printed circuit board manufacturing method according to an embodiment.
FIG. 10 is a diagram for illustrating a printed circuit board manufacturing method according to an embodiment.
FIG. 11 is a diagram for illustrating coupling a printed circuit board and a base according to an embodiment.
FIG. 12 is a diagram for illustrating a printed circuit board and a base being coupled according to an embodiment.
FIG. 13 is a diagram for illustrating a printed circuit board and a base being coupled according to an embodiment.
FIG. 14 is a diagram for illustrating a printed circuit board and a base being coupled according to an embodiment.
FIG. 15 is a block diagram of an electronic device in a network environment, according to various embodiments.
FIG. 16 is a block diagram illustrating a camera module, according to various embodiments.

In relation to descriptions of the drawings, like or similar reference numerals may be used for like or similar components.

### [Mode for the Invention]

Hereinafter, various embodiments of the disclosure are disclosed with reference to the attached drawings. However, it should be understood that this is not intended to limit the disclosure to specific embodiments, and embraces various modifications, equivalents, and/or alternatives of embodiments of the disclosure.

An electronic device according to various embodiments of the disclosure may include, for example, at least one of a smartphone, a tablet personal computer (PC), a mobile phone, a video phone, an e-book reader, a desktop PC, a laptop PC, a netbook computer, a workstation, a server, a personal digital assistant (PDA), a portable multimedia player (PMP), a moving picture experts group (MPEG) 3 (MP3) player, a mobile medical device, a camera, or a wearable device. According to various embodiments, the wearable device may include at least one of an accessory type (e.g., a watch, a ring, a bracelet, an anklet, a necklace, glasses, a contact lens, or a head-mounted-device (HMD)), a fabric or clothing integrated type (e.g., an electronic clothing), a body-mounted type (e.g., a skin pad or a tattoo), and a bio-implantable type (e.g., an implantable circuit).

In some embodiments, the electronic device may be a home appliance. The home appliance may include at least one of, for example, a television, a digital video disk (DVD) player, an audio, a refrigerator, an air-conditioner, a cleaner, an oven, a microwave oven, a washing machine, an air cleaner, a set-top box, a home automation control panel, a security control panel, a TV box, a game console, an electronic dictionary, an electronic key, a camcorder, or an electronic frame.

In an embodiment, the electronic device may include at least one of various medical devices (e.g., various portable medical measuring devices (a blood sugar measuring device, a heartbeat measuring device, a blood pressure measuring device, or a body temperature measuring device), magnetic resonance angiography (MRA), magnetic resonance imaging (MRI), computed tomography (CT), a scanning machine, or an ultrasonic wave device), a navigation device, a global navigation satellite system (GNSS), an event data recorder (EDR), a flight data recorder (FDR), a vehicle infotainment device, marine electronic equipment (e.g., a marine navigation device, or a gyro compass), avionics, a security device, an automotive head unit, an industrial or home robot, an automated teller's machine (ATM) of a financial institution, a point of sales (POS) of a store, or an Internet of things (IoT) device (e.g., a light bulb, various sensors, an electricity or gas meter, a sprinkler device, a fire alarm, a thermostat, a street light, a toaster, sports equipment, a hot water tank, a heater, or a boiler).

According to an embodiment, the electronic device may include at least one of a unit of furniture or building/construction, an electronic board, an electronic signature receiving device, a projector, or various gauging devices (e.g., water supply, electricity, gas, or electric wave gauging device). In various embodiments, the electronic device may be a combination of one or more of the various devices described above. According to some embodiment, the electronic device may be a flexible electronic device. In addition, an electronic device according to an embodiment of this document is not limited to the foregoing devices, and may include a new electronic device according to technological development.

An electronic device according to an embodiment of this document (e.g., any examples or embodiments described herein) may include various electronic devices including a printed circuit board.

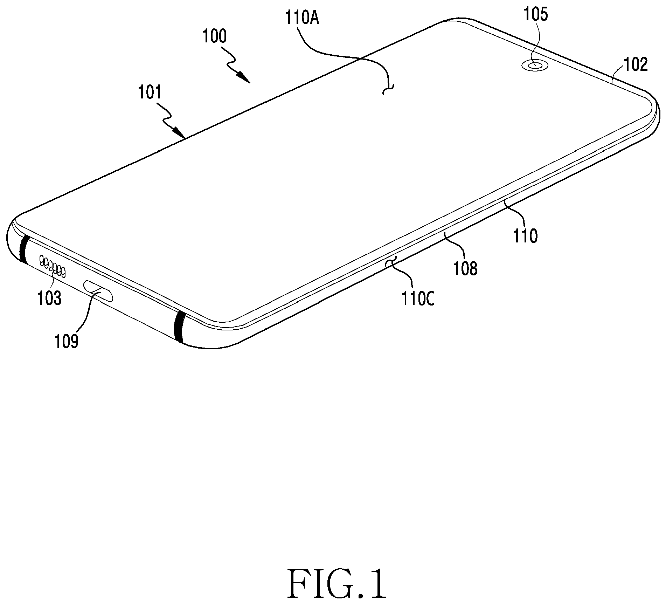

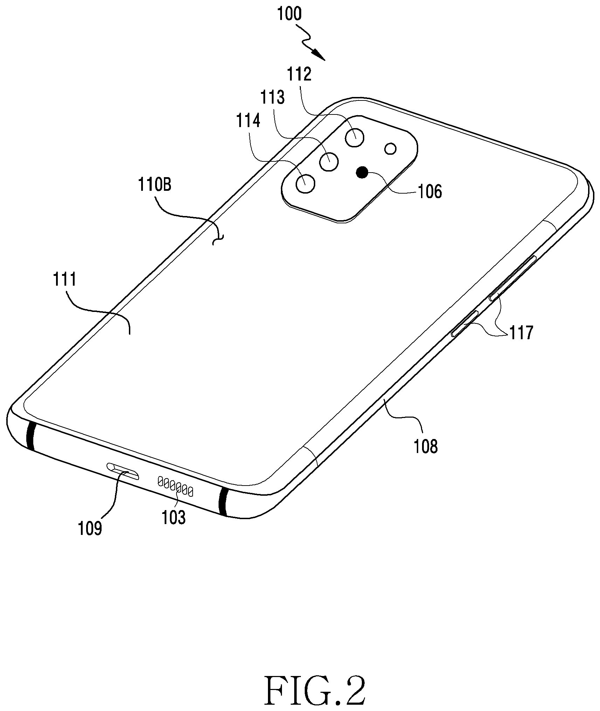

FIG. 1 is a perspective view illustrating a front face of an electronic device (e.g., an electronic device 100 of FIG. 1) according to an embodiment, and FIG. 2 is a perspective view illustrating a rear race of the electronic device 100 of FIG. 1.

The electronic device 100 according to an embodiment of the disclosure is described with a bar-type electronic device as an example, but the following embodiment may be applied to electronic devices such as slidable, rollable, and foldable types, which is not limited thereto.

Referring to FIG. 1 and FIG. 2, the electronic device 100 according to an embodiment may include a housing 110 which includes a first surface (or a "front surface") 110A, a second surface (or a "rear surface") 110B, and a side surface (or a "side wall") 110C surrounding a space between the first surface 110A and the second surface 110B. In another embodiment (not shown), the housing 110 may indicate a structure which forms parts of the first surface 110A, the second surface 110B, and the side surface 110C of FIG. 1 and FIG. 2.

According to an embodiment, the first surface 110A may be formed by a front plate 102 (e.g., a glass plate including various coating layers, or a polymer plate) which is at least in part substantially transparent. According to an embodiment, at least one side edge portion of the front plate 102 may include a curved portion which bends from the first surface 110A and extends seamlessly toward a rear plate 111.

According to an embodiment, the second surface 110B may be formed by a rear plate 111 which is substantially opaque. The rear plate 111 may be formed by, for example, coated or tinted glass, ceramic, polymer, metal (e.g., aluminum, stainless steel (STS), or magnesium), or a combination of at least two of those materials. According to an embodiment, at least one side edge portion of the rear plate 111 may include a curved portion which bends from the second surface 110B and extends seamlessly toward the front plate 102.

According to an embodiment, the side surface 110C may be coupled with the front plate 102 and the rear plate 111, and may be formed by a side member 108 including metal and/or polymer. In an embodiment, the rear plate 111 and the side member 108 may be integrally formed and include the same material (e.g., a metal material such as aluminum).

According to an embodiment, the electronic device 100 may include at least one of a display 101, an audio module 103, a sensor module (not shown), camera modules 105, 112, 113, and 114, a key input device 117 and a connector hole 109. In an embodiment, the electronic device 100 may omit at least one (e.g., the key input device 117) of the components or may additionally include other component.

In an example, the electronic device 100 may include a sensor module which is not shown. For example, the sensor module may be disposed on a rear surface of a screen display area of the display 101 which is visible to outside of the electronic device 100 through the front plate 102.

For example, at least one of an optical sensor, an ultrasonic sensor or a capacitive sensor may be disposed on the rear surface of the screen display area of the display 101, which is not limited thereto.

In an embodiment, the electronic device 100 may further include a light emitting element, and the light emitting element may be disposed at a position adjacent to the display 101 within an area provided by the front plate 102. The light emitting element may provide, for example, state information of the electronic device 100 in the form of light. In an embodiment, the light emitting element may provide, for example, a light source interworking with the operation of the camera module 105. The light emitting element may include, for example, a light emitting diode (LED), an infrared (IR) LED and/or a xenon lamp.

According to an embodiment, the display 101 may be visible to the outside of the electronic device 100 through a significant portion of the front plate 102. In an embodiment, an edge of the display 101 may be formed to be generally the same as an outer peripheral shape (e.g., a curved surface) adjacent to the front plate 102.

According to an embodiment (not shown), the electronic device 100 may form a recess, a notch, or an opening in a part of the screen display area of the display 101, and various electronic components, for example, the camera module 105 or the sensor module which is not shown may be disposed in the recess, the notch, or the opening.

According to an embodiment (not shown), at least one of the camera module (e.g., 112, 113, 114), the fingerprint sensor, and a flash (e.g., 106) may be disposed on the rear surface of the screen display area of the display 101. According to an embodiment (not shown), the display 101 may be combined with or disposed adjacent to a touch sensing circuit, a pressure sensor for measuring an intensity (pressure) of a touch, and/or a digitizer for detecting a magnetic stylus pen.

According to an embodiment, the audio module 103 may include a microphone hole and a speaker hole. A microphone for acquiring external sound may be disposed inside the microphone hole, and a plurality of microphones may be disposed to detect a sound direction in an embodiment. According to an embodiment, the speaker hole and the microphone hole may be implemented as a single hole, or a speaker may be included without the speaker hole (e.g., a piezo speaker). The speaker hole may include, for example, an external speaker hole and a call receiver hole.

The electronic device 100, which includes the sensor module not shown, may generate an electrical signal or a data value corresponding to its internal operating state or an external environmental state. The sensor module may include a proximity sensor disposed on the first surface 110A of the housing 110, a fingerprint sensor disposed on the rear surface of the display 101, and/or a biometric sensor (e.g., a heart rate monitor (HRM) sensor) disposed on the second surface 110B of the housing 110.

The sensor module may further include at least one of, for example, a gesture sensor, a gyro sensor, an air pressure sensor, a magnetic sensor, an acceleration sensor, a grip sensor, a color sensor, an IR sensor, a biosensor, a temperature sensor, a humidity sensor, and an illuminance sensor.

According to an embodiment, the camera modules 105, 112, 113, and 114 may include the first camera module 105 disposed on the first surface 110A of the electronic device 100, and the second camera modules 112, 113, and 114 disposed on the second surface 110B, and/or the flash 106. For example, the above camera modules 105, 112, 113, and 114 may include one or more lenses, an image sensor, and/or an image signal processor. The flash 106 may include, for example, a light emitting diode or a xenon lamp. In an embodiment, two or more lenses (an infrared camera, wide-angle and telephoto lenses) and image sensors may be disposed on one surface of the electronic device 100.

According to an embodiment, the key input device 117 may be disposed in the side surface 110C of the housing 110. In an embodiment, the electronic device 100 may not include a part or whole of the aforementioned key input device 117, and the key input device 117 not included may be implemented in a different form such as a soft key on the display 101. In an embodiment, the key input device 117 may include at least a part of the fingerprint sensor disposed on the second surface 110B of the housing 110.

According to an embodiment, the connector hole 109 may accommodate a connector for transmitting and receiving power and/or data to and from an external electronic device, and/or a connector for transmitting and receiving an audio signal to and from an external electronic device. For example, the connector hole 109 may include a universal serial bus (USB) connector or an earphone jack. In an embodiment, the USB connector and the earphone jack may be implemented as a single hole (e.g., the connector hole 109 of FIG. 1, FIG. 2), and according to an embodiment (not shown), the electronic device 100 may transmit and receive power and/or data, or transmit and receive an audio signal to and from the external electronic device without a separate connector hole.

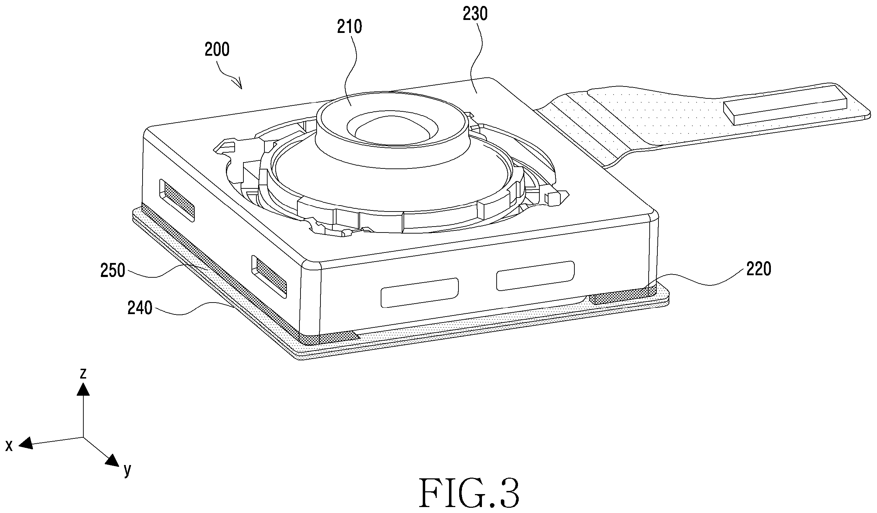

FIG. 3 is a perspective view of a camera module 200 according to an embodiment.

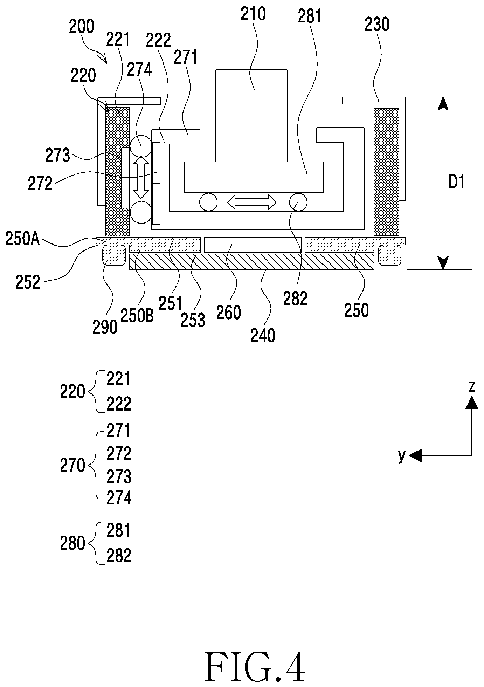

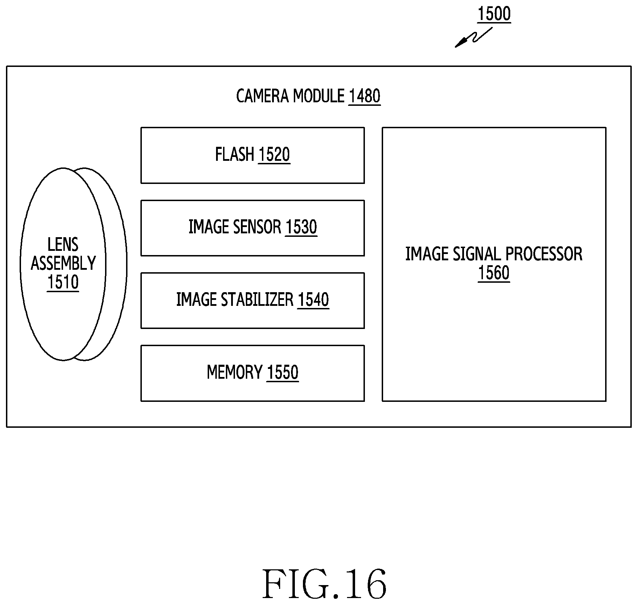

The camera module 200 (e.g., a camera module 1480 of FIG. 16) according to an embodiment may include a lens assembly 210, a housing 220, an image sensor (not shown) (e.g., an image sensor 260 of FIG. 4, or an image sensor 1530 of FIG. 16), a printed circuit board 250 on which the lens assembly 210 is disposed, a base 240 on which the printed circuit board 250 is mounted and an electrical element (not shown) connected to the printed circuit board 250. However, the components of the camera module 200 are not limited thereto. For example, the camera module 200 may omit at least one of the aforementioned components, or may further include at least one other component. For example, the camera module 200 may further include a cover 230 for covering at least a part of the housing 220, the base 240 on which the housing 220 is mounted, a first driving unit (not shown) for driving the AF of the camera module 200 and/or a second driving unit (not shown) for driving the OIS of the camera module 200. In an example, the camera module 200 may include a plurality of electrical elements.

According to an embodiment, the housing 220 and/or the cover 230 may form an exterior of the camera module 200. For example, the housing 220 may provide a frame for supporting other components. A shape of the housing 220 and/or the cover 230 may vary depending on a shape of the camera module 200 or the components included in the camera module 200. For example, the housing 220 and/or cover 230 may be a box-shaped housing. However, it is not limited thereto.

According to an embodiment, the cover 230 may cover at least a part of the housing 220. For example, the cover 230 may cover at least a part of a side surface of the housing 220 (e.g., a surface facing the x-axis or the y-axis) and a top surface of the housing 220. However, it is not limited thereto. For example, the housing 220 may be a single member with the cover 230.

According to an embodiment, the cover 230 may form a space with the housing 220. Components included in the camera module 200 may be disposed in the space formed between the housing 220 and the cover 230. For example, at least one of at least a part of the lens assembly 210, the first driving unit for driving the AF of the camera module 200, or the second driving unit for driving the OIS of the camera module 200 may be disposed in the space. However, it is not limited thereto.

According to an embodiment, the lens assembly 210 (e.g., a lens assembly 1510 of FIG. 16) may include at least one lens disposed to produce an image of a subject on the image sensor (not shown). The camera module 200 may receive light through the lens assembly 210. For example, the light may go into the camera module 200 through at least a part of the at least one lens. In an example, the light may go into the camera module 200 in an optical-axis direction (e.g., the -z-axis direction).

According to an embodiment, at least a part of the lens assembly 210 may be exposed outside the camera module 200. For example, at least a part of the lens assembly 210 may be disposed to protrude from the top surface (e.g., a surface facing in the +z direction) of the housing 220 and/or the cover 230. According to an embodiment, the lens assembly 210 may be disposed on the printed circuit board 250. For example, the lens assembly 210 may be disposed on a top surface (e.g., above the +z-axis direction) of the printed circuit board 250. For example, the lens assembly 210 may be disposed on (mounted on) a first side (upper surface, or top surface) of the printed circuit board.

According to an embodiment, at least a part of the lens assembly 210 may be disposed inside the housing 220. In an example, the lens assembly 210 may be disposed to move based on the housing 220 (or, the cover 230). For example, the lens assembly 210 may be moved in a first direction (e.g., the +z-axis direction or the -z-axis direction) based on the housing 220 by the first driving unit (not shown) for driving the AF (Auto Focus) of the camera module 200. For example, the lens assembly 210 may be moved in at least one of a second direction (e.g., the +x-axis direction or the -x-axis direction) or a third direction (e.g., the +y-axis direction or the -y-axis direction) based on the housing 220 by the second driving unit (not shown) for driving the OIS of the camera module 200. However, it is not limited thereto.

According to an embodiment, the housing 220 may be disposed on the printed circuit board 250. For example, the housing 220 may be disposed on the top surface of the printed circuit board 250 (e.g., above the +z-axis direction). At least a part of the printed circuit board 250 may be disposed on the top surface of the base 240. In an example, at least a part of the housing 220 may be secured to the base 240 on the top surface of the base 240.

According to an embodiment, the image sensor may be disposed on the printed circuit board 250. For example, the image sensor may be coupled to the printed circuit board 250. For example, the image sensor may be attached to the printed circuit board 250. For example, the image sensor may be attached to the base 240. However, it is not limited thereto. For example, the image sensor may be attached to the printed circuit board 250 and/or the base 240. In an example, the image sensor may be surrounded by at least a part of the printed circuit board 250.

According to an embodiment, the base 240 may include (e.g., may be formed in, may comprise) a plate shape. For example, the base 240 may be a quadrangular plate. However, it is not limited thereto. For example, the base 240 may have a shape corresponding to at least a part of the printed circuit board 250. According to an embodiment, the base 240 may include metal. For example, the base 240 may include at least one of a copper alloy or steel use stainless (SUS). However, it is not limited thereto.

According to an embodiment, the housing 220 may be disposed (e.g., attached to) on the printed circuit board 250. For example, the printed circuit board 250 may be disposed between the housing 220 and the base 240. In an example, at least a part of the housing 220 may be disposed on the top surface (e.g., the surface facing the +z-axis direction) of the printed circuit board 250. The printed circuit board 250 may be electrically coupled with the image sensor (not shown).

According to an embodiment, the printed circuit board 250 may include a plate shape. For example, the printed circuit board 250 may be at least in part quadrangular in shape. However, it is not limited thereto.

According to an embodiment, the printed circuit board 250 may be secured to (e.g., disposed on, or attached to) the base 240. For example, the printed circuit board 250 may be fixed to a top surface (e.g., a surface facing the +z-axis direction) of the base 240.

According to an embodiment, the housing 220 may be secured to the printed circuit board 250. For example, the housing 220 may be secured to the top surface (e.g., the surface facing the +z-axis direction) of the printed circuit board 250.

FIG. 4 is a diagram illustrating a camera module 200 according to an embodiment.

The camera module 200 of FIG. 4 may be referred to by the camera module 200 of FIG. 3. The same term and/or the same reference numeral are used for an identical or substantially identical configuration described above, and redundant descriptions are omitted.

Referring to FIG. 4, the printed circuit board 250 according to an embodiment may include a first side 251 (e.g., a surface facing the +z direction, or toward an outside of the camera module) on which the lens assembly 210 (and/or the housing 220) is disposed. The printed circuit board 250 may include a first region 250A having a first thickness in the first direction (e.g., the +z direction or the -z direction) from the first side 251, and a second region 250B having a second thickness in the first direction from the first side 251. The second thickness may be greater than or equal to the first thickness. That is, in an example, the printed circuit board 250 may comprise a first region 250A in which at least a portion (e.g., a rear portion thereof) of a surface is cut away, or removed, wherein the thickness of the first region 250A is therefore less than (or thinner) than the second region 250B (e.g., may form a step between the two regions).

According to an embodiment, the first region 250A of the printed circuit board 250 may be disposed (or arranged) between the first housing 220 and the electrical element 290. In an example, at least a portion, or part, of the first region 250A may be arranged, or disposed, between the housing 220 and the electrical element 290. For example, the first region 250A may at least in part overlap with the electrical element 290 and/or the housing 220 in the first direction (e.g., the +z-axis direction or the -z-axis direction). In an example, the electrical element 290 may be disposed in (arranged in) the first region 250A. For example, the electrical element 290 may be disposed on (e.g., mounted on) a rear surface (e.g., the -z direction) of the first region 250A (e.g., of the printed circuit board 250 in the first region 250A). For example, the electrical element 290 may be disposed on a second side 252 of the first region 250A which is opposite to (e.g., facing away from) the first side 251 of the printed circuit board 250. That is, the electrical element 290 may be disposed, or arranged, on a bottom side (second side 252) of the first region 250A of the printed circuit board.

According to an embodiment, the second region 250B may be disposed (e.g., arranged) between the housing 220 and the base 240. For example, the second region 250B may at least in part overlap with the lens assembly 210, the image sensor 260 and/or the housing 220 in a direction facing the housing 220 (e.g., the +z direction). In other words, in the z (or thickness) direction, the second region 250B may be arranged, or positioned, between the housing 220 and the base 240. The second region 250B may overlap at least in part with the base 240 in a direction facing the base 240 (e.g., the -z direction). In an example, the base 240 may be disposed in (arranged in) the second region 250B. For example, the base 240 may be disposed on a rear surface of the second region 250B of the printed circuit board 250. For example, the base 240 may be disposed on a third side 253 opposite to (e.g., facing away from) the first side 251 of the printed circuit board 250. A length from the first side 251 to the second side 252 may be smaller than or equal to a length from the first side 251 to the third side 253.

According to an embodiment, since the electrical element 290 is disposed in the first region 250A (e.g., at, or on, the rear surface of the first region 250A), a height D1 (e.g., a height in the first direction) of the camera module 200 may be reduced. For example, if the electrical element 290 is not disposed in the first region 250A (e.g., the rear surface of the first region 250A) but is disposed on the top surface (e.g., on the first side 251) of the printed circuit board 250, the housing 220 may form a space for accommodating the electrical element 290. For example, the camera module (e.g., the housing) may require the space for arranging the electrical element 290 between a first carrier 271 and the printed circuit board 250. However, the camera module 200 may not require the space, by arranging the electrical element 290 in the first region 250A (e.g., the rear surface of the first region 250A), as shown in the disclosure. Hence, the height D1 of the camera module 200 may be reduced.

According to an embodiment, the height D1 of the camera module 200 may include a length (or distance) from a reference plane on which the base 240 is disposed in the first direction to the top surface of the housing 220. That is, the base 240 (e.g. a rear surface of base 240) may form a reference plane from which to measure height D1. However, it is not limited thereto. For example, the height D1 of the camera module 200 may include a length (or distance) from the reference plane on which the base 240 is disposed in the first direction to one end of the lens assembly 210. For example, the height D1 of the camera module 200 may include a length from the reference plane on which the base 240 is disposed in the first direction to the top surface of the cover 230.

According to an embodiment, the electrical element 290 may include an electrical element related to the camera module 200. In an example, the electrical element 290 may comprise at least one chip. For example, the electrical element 290 may include a plurality of chips. For example, the electrical element 290 may include at least one of an integrated circuit (IC), a capacitor or a resistor chip. However, it is not limited thereto. In an example, the plurality of the chips may be disposed on the second side 252 of the printed circuit board 250.

According to an embodiment, at least a part of the electrical element 290 may overlap with at least a part of the image sensor 260 in a direction (e.g., the y-axis direction and/or the x-axis direction) substantially perpendicular to the optical-axis direction (e.g., the +z-axis direction or the -z-axis direction) of the camera module 200. For example, the electrical element 290 may overlap with the image sensor 260 in the direction (e.g., the y-axis direction and/or the x-axis direction) substantially perpendicular to the optical-axis direction (e.g., along the +z-axis or the -z-axis direction) of the camera module 200. For example, the electrical element 290 may overlap a part of image sensor 260 in the direction (e.g., the y-axis direction and/or the x-axis direction) substantially perpendicular to the optical-axis direction (e.g., the +z-axis direction or the -z-axis direction) of the camera module 200.

According to an embodiment, the electrical element 290 may overlap with the first region 250A in the first direction (e.g., the +z-axis or the -z-axis direction) corresponding to the optical-axis direction of the camera module 200. According to an embodiment, the electrical element 290 may not overlap with the base 240 in the first direction (e.g., the +z-axis or the -z-axis direction) corresponding to the optical-axis direction of the camera module 200. According to an embodiment, the electrical element 290 may not overlap with the base 240 in the first direction (e.g., the +z-axis or the -z-axis direction) corresponding to the optical-axis direction of the camera module 200, but may overlap with the first region 250A.

According to an embodiment, the lens assembly 210 may have a reference position. For example, the reference position may include a reference position within a movement range of the lens assembly 210. That is, in an example, the reference position may be a central position within a movement range of the lens assembly (e.g., a movement range in response to the lens assembly driven by a driving unit), for example, a movement range in the first direction (e.g., a central position within a movement range of the +z, -z direction, along the optical axis direction). For example, the reference position may include a center position within the movement range of the lens assembly 210. In a further example, the reference position may be a central position with a movement range of the lens assembly in one or more of the x, y or z directions (e.g., a center position between the movement range(s)). However, it is not limited thereto.

According to an embodiment, the distance between the lens assembly 210 and the printed circuit board 250 at the reference position (e.g., when in the center, or central, position) may be smaller than the thickness of the electrical element 290. The thickness of the electrical element 290 may include a thickness in the first direction (e.g., the +z-axis direction or the -z-axis direction).

That is, in an example, the distance between a rear surface of the lens assembly (e.g., a carrier 271) and the printed circuit board in the first (z axis) direction may be less than a thickness of the electrical element 290 in this same direction. In other words, unlike in the case previously discussed where the camera module (e.g., the housing) may require the space for arranging the electrical element 290 between a first carrier 271 and the printed circuit board 250, in examples of the present disclosure, this distance may be instead reduced to be smaller than the thickness of the electrical element 290, owing to the arrangement of the electrical element 290 on the second side of the first region 250A.

According to an embodiment, the camera module 200 may include a first driving unit 270 for the AF control function. The first driving unit 270 may move the lens assembly 210 in the first direction (e.g., the +z-axis direction or the -z-axis direction). According to an embodiment, the first driving unit 270 may include an AF actuator configured to move the lens assembly 210 for the AF control function. For example, the first driving unit 270 may move the lens assembly 210 in the first direction (e.g., the +z-axis direction or the -z-axis direction) in which the distance between the image sensor 260 and the lens assembly 210 is changed for the AF control function.

According to an embodiment, the first driving unit 270 may include the first carrier 271 and at least one first sphere 274. However, the components of the first driving unit 270 are not limited thereto. For example, the first driving unit 270 may omit at least one of the components described above, or may further include at least one other component. For example, the first driving unit 270 may further include at least one of a first magnet 272 or a first coil 273.

According to an embodiment, the first carrier 271 may carry at least a part of the second driving unit 280 accommodating the lens assembly 210 in the first direction (e.g., the +z-axis direction or the -z-axis direction). For example, the first carrier 271 may carry the second carrier 281 accommodating the lens assembly 210 in the first direction. In an example, the first carrier 271 may surround at least a part of the second carrier 281. For example, the first carrier 271 may surround at least a part of sides of the second carrier 281.

According to an embodiment, the at least one first sphere 274 may be disposed between the first carrier 271 and the housing 220. For example, the at least one first sphere 274 may be disposed between the first carrier 271 and a first side 221 of the housing 220. The at least one first sphere 274 may be disposed to move the first carrier 271 in the first direction with respect to the housing 220. For example, the at least one first sphere 274 may be disposed side by side along the first direction.

According to an embodiment, the first magnet 272 may be disposed on a first side 222 (e.g., a side facing the +y-axis direction) of the first carrier 271. The first magnet 272 may be disposed to face the first coil 273. The first coil 273 may be disposed in the housing 220 (e.g., the first side 221 of the housing 220) facing the first side 222 of the first carrier 271 on which the first magnet 272 is disposed. The first carrier 271 may be moved based on the housing 220 (or, the base 240, the printed circuit board 250 or the image sensor 260) by a force in the first direction (e.g., the +z-axis direction or the -z-axis direction) exerted on the first magnet 272 by a magnetic field generated by current flowing through the first coil 273. As the first carrier 271 moves, the lens assembly 210 may be moved in the first direction. As the first carrier 271 moves, the distance from the image sensor 260 to the lens assembly 210 may change.

According to an embodiment, the first carrier 271 may include at least one first guide portion (not shown) for guiding the at least one first sphere 274 to move in the first direction. For example, the first side 222 of the first carrier 271 may include the at least one first guide portion. The at least one first guide portion may be formed in the first direction to move the first carrier 271 in the first direction. In an example, the first guide portion may have, but not limited to, a guide groove or rail shape.

According to an embodiment, the at least one first sphere 274 may be disposed on the at least one first guide portion. The at least one first guide portion may guide the at least one first sphere 274 to move in the first direction. For example, the at least one first sphere 274 may be moved, rolled, rotated, or tilted on the at least one first guide portion.

According to an embodiment, by guiding the at least one first sphere 274 along the at least one first guide portion, the first carrier 271 may be carried in the first direction (e.g., the +z-axis or the -z-axis direction). If the first carrier 271 is carried in the first direction, at least a part (e.g., the second carrier 281) of the second driving unit 280 disposed on the first carrier 271 may be carried in the first direction. By moving at least a part of the second driving unit 280, the lens assembly 210 may be carried in the first direction. Although not depicted in FIG. 4, the housing 220 may include a guide portion formed at a position corresponding to the first guide portion of the first carrier 271.

According to an embodiment, the lens assembly 210 may move together with the first carrier 271. For example, since the lens assembly 210 is coupled with the second carrier 281, the lens assembly 210 may move together with the second carrier 281. For example, if the second carrier 281 moves in the second direction (e.g., the +x-axis direction or the -x-axis direction), the lens assembly 210 may move in the second direction. For example, if the second carrier 281 moves in the third direction (e.g., the +y-axis direction or the -y-axis direction), the lens assembly 210 may move in the third direction. For example, since the second carrier 281 is accommodated in the first carrier 271, if the first carrier 271 moves in the first direction (e.g., the +z-axis direction or the -z-axis direction), the second carrier 281 may move in the first direction, and the lens assembly 210 may move in the first direction.

According to an embodiment, the camera module 200 may include the second driving unit 280 for optic image stabilization functionality. The second driving unit 280 may move the lens assembly 210 in the second direction (e.g., the +x-axis direction or the -x-axis direction) and/or the third direction (e.g., the +y-axis direction or the -y-axis direction). The second direction and the third direction may be different directions (e.g., the second and third directions may be substantially perpendicular to the first direction). According to an embodiment, the second driving unit 280 may include an optic image stabilization (OIS) actuator configured to move the lens assembly 210 for the OIS. For example, for the OIS, the second driving unit 280 may move in a direction (e.g., the +z-axis direction or the -z-axis direction) substantially perpendicular to the first direction in which the distance between the lens assembly 210 and the image sensor 260 changes.

According to an embodiment, the second driving unit 280 may include the second carrier 281 which carries the lens assembly 210 in the second direction (e.g., the +x-axis direction or the -x-axis direction) and/or the third direction (e.g., the +y-axis direction or the - y-axis direction). In an example, the lens assembly 210 may be coupled with the second carrier 281. However, it is not limited thereto.

According to an embodiment, a second magnet (not shown) may be disposed on a first side (e.g., a side facing the first side 222 of the first carrier 271) of the second carrier 281. The second magnet may be disposed to face a second coil (not shown). The second coil may be disposed in the housing 220 facing the first side of the second carrier 281 on which the second magnet is disposed. The second carrier 281 may be moved based on the housing 220 (or, the base 240, the printed circuit board 250, the image sensor 260) by a force in the second direction (e.g., the +x-axis direction or the -x-axis direction) exerted on the second magnet by a magnetic field generated by current flowing through the second coil. As the second carrier 281 moves, the lens assembly 210 may be moved in the second direction.

According to an embodiment, a third magnet (not shown) may be disposed on a second side (e.g., a side facing in a direction substantially perpendicular to the first side of the second carrier 281) of the second carrier 281. The third magnet may be disposed to face a third coil (not shown). The third coil may be disposed in the housing 220 facing the second side of the second carrier 281 on which the third magnet is disposed. The second carrier 281 may be moved based on the housing 220 (or, the base 240, the printed circuit board 250, the image sensor 260) by a force in a third direction (e.g., the +y-axis direction or the -y-axis direction) exerted on the third magnet by a magnetic field generated by current flowing through the third coil. As the second carrier 281 moves, the lens assembly 210 may be moved in the third direction.

According to an embodiment, the first side of the second carrier 281 may be substantially perpendicular to the second side of the second carrier 281. The second magnet may be disposed substantially perpendicular to the third magnet. The second coil may be disposed substantially perpendicular to the third coil.

According to an embodiment, the first side of the second carrier 281 may be substantially perpendicular to the first side 221 (e.g., the side facing the +y-axis direction) on which the first magnet 272 (or, the at least one first sphere 274) of the first carrier 271 is disposed. The second magnet may be disposed to be substantially perpendicular to the first magnet 272. The second coil may be disposed to be substantially perpendicular to the first coil 273. The third magnet may be disposed on an opposite side of the first magnet 272. The third magnet may be disposed substantially parallel to the first magnet 272. The third coil may be disposed on an opposite side of the first coil 273. The third coil may be disposed substantially parallel to the first coil 273. However, it is not limited thereto. For example, the second magnet and the third magnet may be disposed substantially perpendicular to the first magnet 272, and the second magnet may be disposed on an opposite side of the third magnet. For example, the second coil and the third coil may be disposed substantially perpendicular to the first coil 273, and the second coil may be disposed substantially parallel to the third coil.

According to an embodiment, the second driving unit 280 for the OIS driving may include the second carrier 281 coupled with the lens assembly 210, and a third carrier (not shown) which carries the second carrier 281 in the third direction (e.g., the +y-axis direction or the -y-axis direction). For example, since the second carrier 281 is disposed on the third carrier, the second carrier 281 may be carried in the third direction as the third carrier moves in the third direction. For example, the second carrier 281 and/or the third carrier may be moved in the second direction and/or the third direction by the at least one sphere 282 disposed between the second carrier 281 (and/or the third carrier) and the first carrier 271.

According to an embodiment, if the second driving unit 280 further includes the third carrier, at least one third sphere (not shown) may be disposed between the second carrier 281 and the third carrier. The second carrier 281 may be moved on the third carrier by the at least one third sphere. For example, the second carrier 281 may be moved on the third carrier by the at least one third sphere, in the second direction (e.g., the +x-axis direction or the -x-axis direction) based on the housing 220 (or, the base 240, the printed circuit board 250, the image sensor 260). However, it is not limited thereto. For example, the third carrier and the at least one third sphere may be omitted from the camera module 200.

According to an embodiment, if the second driving unit 280 further includes the third carrier, at least one of the second carrier 281 or the third carrier may include at least one third guide portion (not shown) for guiding the at least one third sphere to move in the second direction. The at least one third sphere may be disposed on the at least one third guide portion. By guiding (e.g., moving, rolling, rotating, or tilting) the at least one third sphere disposed between the second carrier 281 and the third carrier along the at least one third guide portion, the second carrier 281 may move in the second direction. If the second carrier 281 moves in the second direction, the lens assembly 210 accommodated in the second carrier 281 may move together in the second direction.

According to an embodiment, if the second driving unit 280 further includes the third carrier, at least one fourth sphere (not shown) may be disposed between the first carrier 271 and the third carrier. The third carrier may be moved on the first carrier 271 by the at least one fourth sphere. For example, the third carrier may be moved on the first carrier 271 by the at least one fourth sphere, in the third direction (e.g., the +y-axis direction or the -y-axis direction) based on the housing 220 (or, the base 240, the printed circuit board 250, the image sensor 260).

According to an embodiment, at least one of the first carrier 271 or the third carrier may include at least one fourth guide portion (not shown) for guiding the at least one fourth sphere to move in the third direction. The at least one fourth sphere may be disposed on the at least one fourth guide portion. By guiding (e.g., moving, rolling, rotating, or tilting) the at least one fourth sphere disposed between the first carrier 271 and the third carrier along the at least one fourth guide portion, the third carrier may be moved in the third direction. If the third carrier moves in the third direction, the second carrier 281 accommodated in the third carrier may be carried together in the third direction. If the second carrier 281 is carried in the third direction, the lens assembly 210 accommodated in the second carrier 281 may be carried together in the third direction.

According to an embodiment, at least one of the at least one third guide portion (not shown) or the at least one fourth guide portion (not shown) may have, but not limited to, a guide groove or rail shape. In an example, the at least one third guide portion may be formed in the second direction to guide the at least one third sphere along the second direction. In an example, the at least one fourth guide portion may be formed in the third direction to guide the at least one fourth sphere along the third direction.

In the disclosure, the meaning of 'guide' may embrace moving, rolling, rotating, or tilting.

According to an embodiment, at least one of the first carrier 271 or the second carrier 281 may be opened in the first direction (e.g., may be open, or may comprise an opening in the first direction).For example, at least one of the first carrier 271 or the second carrier 281 may form a space in a portion corresponding to the image sensor 260. For example, at least one of the first carrier 271 or the second carrier 281 may form an opening in the portion corresponding to the image sensor 260. For example, when viewed from above at least one of the first carrier 271 or the second carrier 281 (e.g., when viewed down in the -z-axis direction), the image sensor 260 may be visible.

According to an embodiment, at least one of the housing 220 or the cover 230 may limit the movement range of the driving unit of the camera module. For example, at least one of the side portions of the housing 220 or the side portions of the cover 230 may limit the movement range of the first driving unit 270 and/or the second driving unit 280 in at least one of the second direction (e.g., the +x-axis direction or the -x-axis direction) or the third direction (e.g., the +y-axis direction or the -y-axis direction). For example, the cover 230 may limit the movement range of the first driving unit 270 in the first direction (e.g., the +z-axis direction or the -z-axis direction).

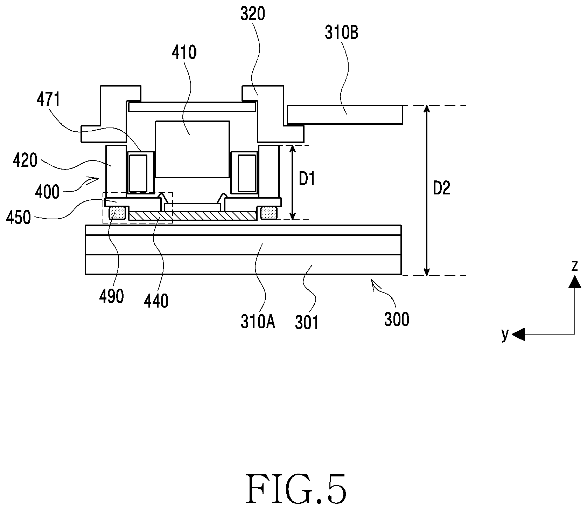

FIG. 5 is a diagram illustrating a camera module disposed inside an electronic device according to an embodiment.

An electronic device 300 of FIG. 5 may be referred to by the electronic device of FIG. 1, the electronic device of FIG. 2, the electronic device of FIG. 3 and/or the electronic device of FIG. 4, and reference may be made herein to the description accompanying these Figures in respect of FIG. 5. The same term and/or the same reference numeral are used for an identical or substantially identical configuration mentioned above.

According to an embodiment, the electronic device 300 may include a first plate 310A, a second plate 310B facing the first plate 310A, a side member (not shown) surrounding a space between the first plate 310A and the second plate 310B, and at least one camera module 400 disposed inside the space. However, the components of the electronic device 300 are not limited thereto. For example, the electronic device 300 may omit at least one of the components described above, or may further include at least one other component. For example, referring to FIG. 5, the electronic device 300 may further include a cover member 320 covering the camera module 400 and/or a display 301 disposed on the first plate 310A.

According to an embodiment, at least one of the first plate 310A, the second plate 310B, or the side member may be formed integrally, or may be formed individually. At least one of the first plate 310A, the second plate 310B, or the side member may form an inner space of the electronic device 300.

According to an embodiment, the camera module 400 may be disposed inside the electronic device 300. For example, the camera module 400 may be accommodated in the inner space formed by at least one of the first plate 310A, the second plate 310B, or the side member. According to an embodiment, the camera module 400 may be disposed with the base 440 facing the first plate 310A and at least one lens of the lens assembly 410 facing the second plate 310B (or, the cover member 320).

Referring to FIG. 5, a printed circuit board 450 according to an embodiment may include a first side (e.g., the first side 251 of FIG. 4) on which the housing 420 and/or the lens assembly 410 is disposed. The printed circuit board 450 may include a first region (e.g., the first region 250A of FIG. 4) having a first thickness from the first side, and a second region (e.g., the second region 250B of FIG. 4) having a second thickness from the first side. The second thickness may be greater than or equal to the first thickness. However, it is not limited thereto.

According to an embodiment, the first region may be spaced apart from the first plate 310A (or, the display 301) by a third length (e.g., a first distance) in a direction (e.g., the +z direction) from the first plate 310A (or, the display 301) toward the second plate 310B. The second region may be spaced apart from the first plate 310A (or, the display 301) by a fourth length (e.g., a second distance) in a direction (e.g., the +z direction) from the first plate 310A (or, the display 301) toward the second plate 310B. In an example, the third length may be greater than or equal to the fourth length. In an example, the third length (or distance) may be greater than the fourth length (or distance), such that the first region is spaced further apart from the first plate than the second region, or alternatively, that the second region is disposed closer to the first plate. However, it is not limited thereto.

According to an embodiment, the first region (e.g., the first region 250A of FIG. 4) may be disposed between the first housing 420 and the electrical element 490. For example, the first region may overlap at least in part with the electrical element 490 and/or the housing 420 in the first direction (e.g., the +z-axis direction or the -z-axis direction). In an example, the electrical element 490 may be disposed in the first region. For example, the electrical element 490 may be disposed on a rear surface (e.g., the -z-axis direction) of the first region. For example, the electrical element 490 may be disposed on a second side (e.g., the second side 252 of FIG. 4) of the printed circuit board 450 disposed opposite to (e.g., facing away) the first side (e.g., the first side 251 of FIG. 4).

According to an embodiment, the second region (e.g., the second region 250B of FIG. 4) may be disposed between the first housing 420 and the base 440. For example, the second region may overlap at least in part with the base 440 and/or the housing 420 in the first direction. In an example, the base 440 may be disposed in the second region. For example, the base 440 may be disposed on a rear side (e.g., the -z-axis direction) of the second region. For example, the base 440 may be disposed on a third side (e.g., the third side 253 of FIG. 4) of the printed circuit board 450 disposed opposite to (e.g., facing away from) the first side. A length from the first side to the second side may be smaller than or equal to a length from the first side to the third side. However, it is not limited thereto.

According to an embodiment, the electrical element 490 may be disposed (arranged, or positioned) between the first region of the printed circuit board 450 and the first plate 310A (or, the display 301).

According to an embodiment, the base 440 may be disposed between the second region of the printed circuit board 450 and the first plate 310A (or, the display 301).

According to an embodiment, since the electrical element 490 is disposed in the first region (e.g., the rear surface of the first region), the height D1 (e.g., the height in the first direction) of the camera module 400 may be reduced. For example, if the electrical element 490 is not disposed in the first region (e.g., the rear surface of the first region) but is disposed on the top surface (e.g., the first surface) of the printed circuit board 450, the housing 420 may form a space for accommodating the electrical element 490. For example, the camera module (e.g., the housing) may require a space between the first carrier 471 and the printed circuit board 450 to arrange the electrical element 490. However, as disclosed herein, the camera module 400 may not require the space, by arranging the electrical element 490 in the first region (e.g., the rear surface of the first region). Thus, the height D1 of the camera module 400 may be reduced.

According to an embodiment, the height D1 of the camera module 400 may include a length from a reference plane on which the base 440 is disposed to the top surface of the housing 420 in the first direction. However, it is not limited thereto. For example, the height D1 of the camera module 400 may include a length from the reference plane on which the base 440 is disposed to one end of the lens assembly 410 in the first direction. For example, the height D1 of the camera module 400 may include a length from the reference plane on which the base 440 is disposed to the top surface of the cover member 320 in the first direction.

According to an embodiment, as the height D1 of the camera module 400 is reduced, the thickness D2 of the electronic device 300 may be reduced. In an embodiment, the thickness D2 of the electronic device 300 may include a length (or distance) between the first plate 310A (or, the display 301) and the second plate 310B in a direction from the first plate 310A toward the second plate 310B. However, it is not limited thereto. For example, the thickness D2 of the electronic device 300 may include a length from the first plate 310A (or, the display 301) to the top surface of the cover member 320 in a direction from the first plate 310A toward the second plate 310B.

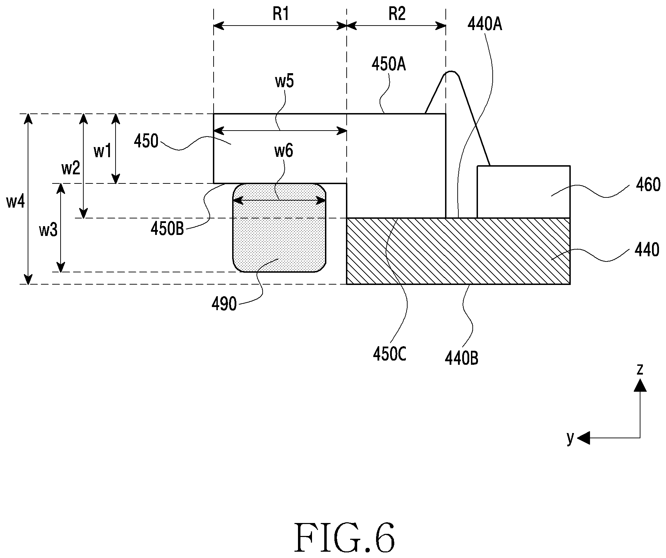

FIG. 6 is a diagram for illustrating a printed circuit board including a first region and a second region according to an embodiment.

FIG. 6 may be the diagram illustrating a part of the camera module 400 of FIG. 5. For example, FIG. 6 may be the diagram illustrating a part of the printed circuit board 450, a part of the base 440 and a part of the image sensor 460 of FIG. 5.

The camera module of FIG. 6 may be referred to by the camera module 105 of FIG. 1, the camera modules 112, 113, and 114 of FIG. 2, the camera module 200 of FIG. 3, the camera module 200 of FIG. 4 and/or the camera module 400 of FIG. 5 and reference may be made herein to the description accompanying these Figures in respect of FIG. 6. The same term and/or the same reference numeral are used for an identical or substantially identical configuration as described above.

Referring to FIG. 6, the printed circuit board 450 according to an embodiment may include a first region R1 and a second region R2. The first region R1 may include a region having a first thickness w1 in the first direction (e.g., the +z direction or the -z direction) from a first surface 450A (e.g., the first side 251 of FIG. 4) of the printed circuit board 450. The second region R2 may include a region having a second thickness w2 which is greater than or equal to the first thickness w1 in the first direction from the first surface 450A.

According to an embodiment, the first region R1 may include a second surface 450B (e.g., the second side 252 of FIG. 4) which is an opposite surface of the first surface 450A. In an example, the electrical element 490 may be disposed on a rear surface (e.g., a surface facing the -z direction) of the first region R1. For example, the electrical element 490 may be disposed on the second surface 450B.

According to an embodiment, the first region R1 may include a region formed by removing at least a part of the printed circuit board 450 to form a space for the electrical element 490 to be disposed on the rear surface of the printed circuit board 450 (e.g., a surface facing in the -z direction).

According to an embodiment, the second region R2 may include a third surface 450C (e.g., the third side 253 of FIG. 4) which is an opposite surface of the first surface 450A. In an example, the third surface 450C may be substantially parallel to the second surface 450B. However, it is not limited thereto.

In an example, the base 440 may be disposed on a rear surface (e.g., a surface facing in the -z direction) of the second region R2. For example, the base 440 may be disposed on the third surface 450C. For example, the second region R2 may be disposed on the base 440.

According to an embodiment, the second region R2 may include a region in which at least a part of the printed circuit board 450 is not removed to form the space for arranging the electrical element 490 on the rear surface (e.g., the surface facing in the -z direction) of the printed circuit board 450. For example, the second region R2 may include a region having a step from the first region R1 with at least a part of the printed circuit board 450 removed.

According to an embodiment, the base 440 may include a first surface 440A facing the third surface 450C, and a second surface 440B positioned opposite to (e.g., facing away from) the first surface 440A. In an example, the first surface 440A of the base 440 may face the second region R2. For example, the first surface 440A of the base 440 may face the third surface 450C of the second region R2.

According to an embodiment, the image sensor 460 may be disposed on the base 440. For example, the image sensor 460 may be disposed on the first surface 440A of the base 440.

According to an embodiment, the first region R1 may have the first thickness w1 in the first direction (e.g., the z direction or the -z direction). The electrical element 490 may have a third thickness w3 in the first direction. A thickness corresponding to a length from the first surface 450A of the printed circuit board 450 to the reference plane (e.g., the second surface 440B of the base 440) having the base 440 in the first direction may have a fourth thickness w4. In an example, the fourth thickness w4 may correspond to a sum of the thickness of the base 440 and the thickness of the second region R2. In an example, the sum of the first thickness w1 and the third thickness w3 may be smaller than or equal to the fourth thickness w4. For example, the electrical element 490 may be disposed between the second surface 450B of the first region R1 and the second surface 440B of the base 440.

According to an embodiment, the electrical element 490 may overlap with at least a part of the second region R2 in a direction substantially perpendicular to the first direction (e.g., the x-axis direction and/or the y-axis direction). For example, at least a part of the electrical element 490 may overlap with at least a part of the second region R2 in the perpendicular direction, and a remaining part may overlap with at least a part of the base 440 in the perpendicular direction (e.g., when viewed from the perpendicular direction).

According to an embodiment, a width of the first region R1 may have a first width w5 in a direction (e.g., the x-axis direction or in the y-axis direction) substantially perpendicular to the first direction. The width of the electrical element 490 may have a second width w6 in a direction (e.g., the x-axis direction or the y-axis direction) substantially perpendicular to the first direction. In an example, the second width w6 may be smaller than or equal to the first width w5. However, it is not limited thereto.

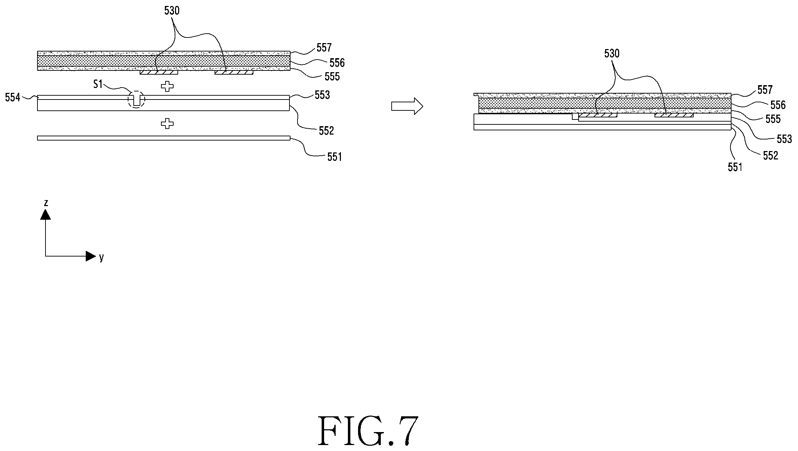

FIG. 7 through FIG. 10 may be diagrams for illustrating a manufacturing method of a printed circuit board according to an embodiment. For example, FIG. 7 through FIG. 9 may be the diagrams for illustrating the manufacturing method of a first region and a second region of the printed circuit board (e.g., in accordance with any of FIG. 1 to FIG. 6).

FIG. 7 is the diagram for illustrating a first process and a second process of the printed circuit board manufacturing method according to an embodiment.

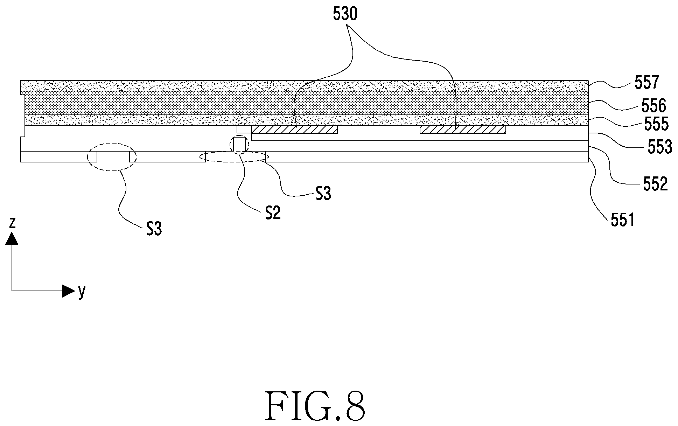

FIG. 8 is the diagram for illustrating a third process of the printed circuit board manufacturing method according to an embodiment.

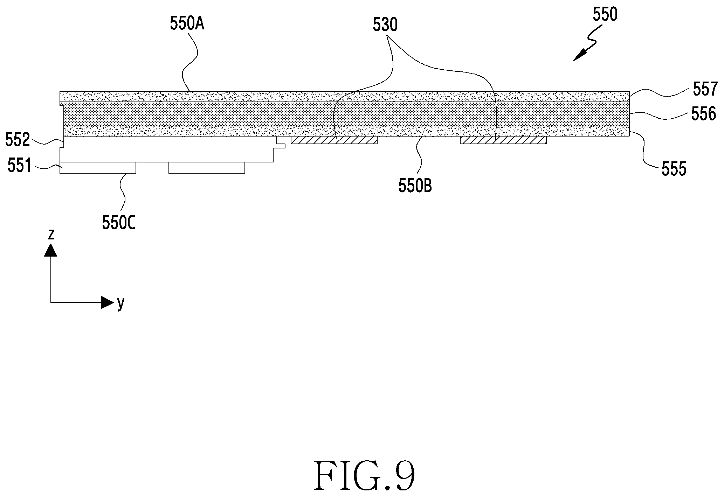

FIG. 9 is the diagram for illustrating a fourth process of the printed circuit board manufacturing method according to an embodiment.

The printed circuit board of FIG. 7 through FIG. 9 may be referred to by the printed circuit board 250 of FIG. 3, the printed circuit board 250 of FIG. 4, the printed circuit board 450 of FIG. 5, and/or the printed circuit board 450 of FIG. 6, and reference is made to any of the description described therein. The same term is used for the same or substantially the same configuration mentioned above.

Referring to FIG. 7, an insulation layer 556 may be disposed on a top surface of a second circuit layer 555 (e.g., above the +z direction), and a third circuit layer 557 may be disposed on a top surface of the insulation layer 556. The second circuit layer 555, the insulation layer 556, and the third circuit layer 557 may form a first printed circuit board assembly. However, it is not limited thereto. For example, the first printed circuit board assembly may omit at least one of the configurations described above, or may further include at least one circuit layer and/or insulation layer.

According to an embodiment, the first printed circuit board assembly may include at least one pad 530. For example, the at least one pad 530 may be disposed on a rear surface (e.g., a surface facing in the -Z direction) of the second circuit layer 555.

According to an embodiment, the first printed circuit board assembly may be disposed on a top surface of the first circuit layer 551. For example, the first printed circuit board assembly may be bonded to the first circuit layer 551. Referring to FIG. 7, the first printed circuit board assembly may be bonded to the first circuit layer 551 by an adhesive 552.

According to an embodiment, a tape 553 may be disposed on a top surface of the adhesive 552. For example, the tape 553 may include a tape having no adhesive on at least one surface. For example, the tape 553 may include a release paper tape. However, it is not limited thereto. Referring to FIG. 7, one surface (e.g., a top surface facing in the +z direction) of the tape 553 facing the second circuit layer 555 may include a non-adhesive surface.

According to an embodiment, with the tape 553 disposed on the top surface of the adhesive 552, at least a part of the tape 553 and the adhesive 552 may be removed. For example, referring to a first portion S1, at least a part of the tape 553 and the adhesive 552 may be cut. For example, at least a part of the tape 553 and the adhesive 552 may be cut in the +z direction.

According to an embodiment, with at least a part of the tape 553 and the adhesive 552 cut by the first portion S1, at least a part 554 of the tape 553 may be removed. For example, a part of the tape 553 other than the part corresponding to the first region (e.g., the first region R1 of FIG. 6) of the printed circuit board may be removed. For example, the part 554 of the tape 553 corresponding to the second region (e.g., the second region R2 in FIG. 6) of the printed circuit board may be removed.

According to an embodiment, if the first printed circuit board assembly is coupled to the first circuit layer 551 using the adhesive 552, a part of the adhesive 552 corresponding to the first region (e.g., the first region R1 of FIG. 6) may not be bonded to the first printed circuit board assembly (e.g., the second circuit layer 555) by the tape 553. The part of the adhesive 552 corresponding to the second region (e.g., the second region R2 of FIG. 6) may be bonded to the first printed circuit board assembly (e.g., the second circuit layer 555).

According to an embodiment, a second printed circuit board assembly may be formed by coupling the first printed circuit board assembly with the first circuit layer 551 using the adhesive 552. For example, the second printed circuit board assembly may include, in a part corresponding to the first region of the printed circuit board, the first circuit layer 551, the adhesive 552 disposed on the top surface of the first circuit layer 551, the tape 553 disposed on the top surface of the adhesive 552, the second circuit layer 555 disposed on the top surface of the tape 553, the insulation layer 556 disposed on the top surface of the second circuit layer 555, and the third circuit layer 557 disposed on the top surface of the insulation layer 556. However, the configuration of the second printed circuit board assembly is not limited thereto. For example, the second printed circuit board assembly may omit at least one of the configurations described above, or may further include at least one other configuration.

According to an embodiment, the printed circuit boards (e.g., the first printed circuit board assembly and/or the second printed circuit board assembly) may be stacked using a press process. However, it is not limited thereto.

Referring to FIG. 8, at least a part of the second printed circuit board assembly according to an embodiment may be removed. For example, referring to a second portion S2, at least a part of the adhesive 552 may be cut. For example, at least a part of the adhesive 552 may be cut in the +z direction. By cutting the at least a part of the adhesive 552, at least a part of the second printed circuit board assembly may be easily removed.

According to an embodiment, at least a part of the adhesive 552 may be cut using a laser. However, it is not limited thereto.

According to an embodiment, a circuit may be formed on at least one circuit layer of the second printed circuit board assembly. For example, referring to a third portion S3, a circuit may be formed in the first circuit layer 551, by cutting the first circuit layer 551 at least in part. In an example, the circuit may be formed on the circuit layer using an etching process. However, it is not limited thereto.

Referring to FIG. 9, at least a part of the second printed circuit board assembly may be removed. For example, at least a part of the portion of the second printed circuit board assembly corresponding to the first region (e.g., the first region R1 of FIG. 6) may be removed. For example, the part not bonded to the first printed circuit board assembly by the tape 553 may be removed. For example, at least a part of the first circuit layer 551, at least a part of the adhesive 552, and the tape 553 may be removed.

According to an embodiment, by removing at least a part of the second printed circuit board assembly, a first region and a second region (e.g., the second region R2 of FIG. 6) of the printed circuit board 550 may be formed. For example, the printed circuit board 550 may include a first surface 550A, a second surface 550B of the first region positioned opposite to (e.g., facing away from) the first surface 550A, and a third surface 550C of the second region positioned opposite to (e.g., facing away from) the first surface 550A.

According to an embodiment, the first region may have a thickness of a first length from the first surface 550A to the second surface 550B in the first direction (e.g., the -z direction). The second region may have a thickness of a second length from the first surface 550A to the third surface 550C in the first direction. In an example, the first length may be smaller than or equal to the second length.

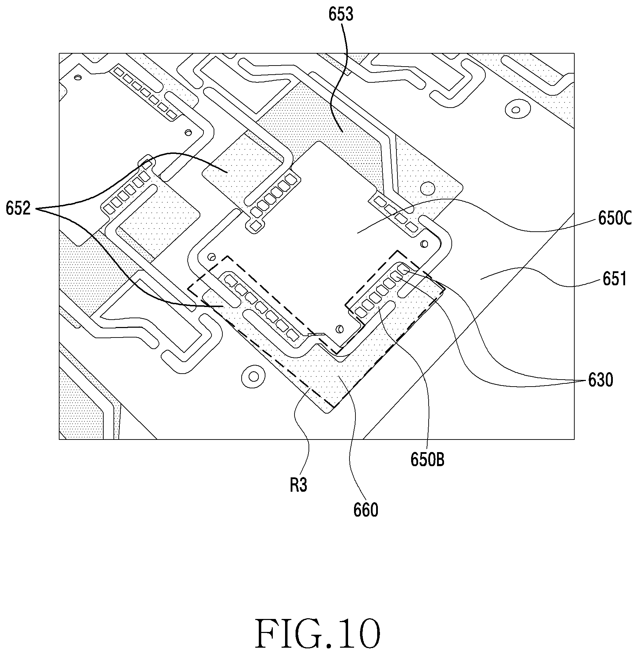

FIG. 10 is the diagram for illustrating the printed circuit board manufacturing method according to an embodiment.

Content of FIG. 10 may be referred to by the contents of FIG. 1 through FIG. 9 above. The same term is used for the same or substantially the same configuration as mentioned above.

FIG. 10 may be the diagram illustrating that at least a part of the second printed circuit board assembly is removed. For example, the printed circuit board of FIG. 10 may be referred by the printed circuit board 550 of FIG. 9.

According to an embodiment, the second printed circuit board assembly may include a first layer 651, and a second layer disposed below the first layer 651. In an example, the first layer 651 may include a circuit layer (e.g., the first circuit layer 551 of FIG. 8). However, it is not limited thereto. In an example, the second layer may include a plurality of pads (e.g., at least one pad 530 of FIG. 8), a first surface treated first part 652, or a second surface treated second part 653. In an example, the second part 653 may include at least one of a printed circuit board or a flexible circuit board. A plurality of electrical element 630 may be disposed on the plurality of the pads.

According to an embodiment, if at least a part of the second printed circuit board assembly (e.g., see FIG. 9) is removed, the region corresponding to the first region (e.g., the first region R1 of FIG. 6) in the second printed circuit board assembly may be removed together with at least a part of an outer region 660 of the second printed circuit board assembly. For example, referring to FIG. 10, a portion corresponding to a third region R3 in the second printed circuit board assembly may be removed. For example, a portion corresponding to the third region R3 of the first layer 651 may be removed. By removing the portion corresponding to the third region R3 in the first layer 651, the portion corresponding to the third region R3 in the second layer may be visible from the outside. For example, the portion corresponding to the third region R3 in the first part 652, the portion corresponding to the third region R3 in the second part 653, or at least one of the plurality of the pads may be visible from the outside. The third region R3 of FIG. 10 illustrates one example of the region where at least a part of the second printed circuit board assembly (e.g., the first layer 651) is removed, and the third region R3 is not limited to the illustration in FIG. 10. In an example, the portion of the second printed circuit board assembly corresponding to the third region R3 may include at least a part of at least one of the first circuit layer 551, the adhesive 552, or the tape 553 of FIG. 8.

In an example, the third region R3 may include a region corresponding to the first region and at least a part (e.g., a region adjacent to the first region of the outer region 660) of the outer region 660. FIG. 10 may be the diagram illustrating that the first layer 651 corresponding to the third region R3 is removed.

According to an embodiment, by removing the portion (e.g., the portion corresponding to the third region R3 of the first layer 651) corresponding to the third region R3 of the second printed circuit board assembly, the region corresponding to the first region may be easily removed.

According to an embodiment, by removing the portion (e.g., a portion corresponding to the third region R3 of the first layer 651) corresponding to the third region R3 of the second printed circuit board assembly, at least one side of the printed circuit board may include at least one side of the first region.

According to an embodiment, by removing the portion (e.g., a portion corresponding to the third region R3 of the first layer 651) corresponding to the first region of the second printed circuit board assembly, a first region and a second region (e.g., the second region R2 of FIG. 6) may be formed. The first region may include a second surface 650B facing in the first direction. In an example, the second surface 650B may include the first part 652, the second part 653, or at least one of the plurality of the pads. The second region may include a third surface 650C facing in the first direction. The third surface 650C may be disposed at a position protruding farther in the first direction than the second surface 650B.

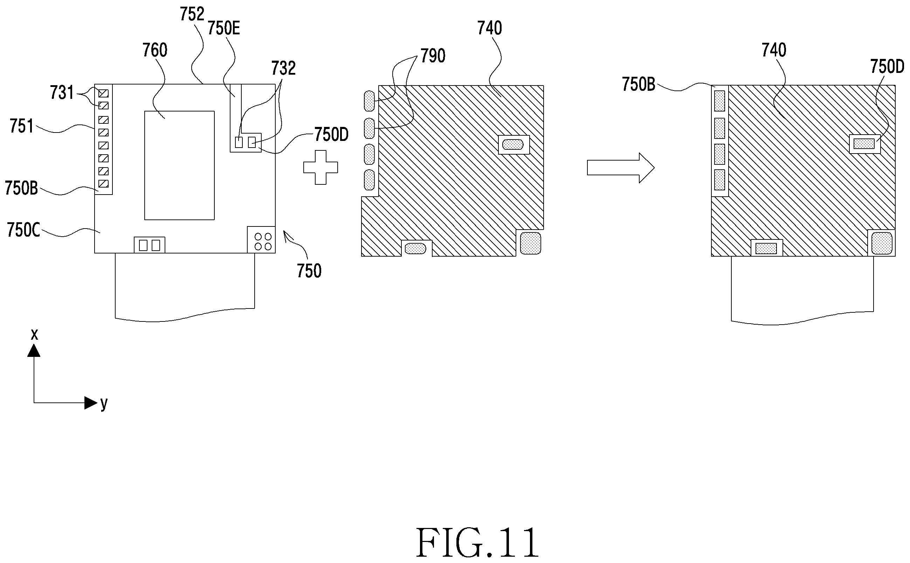

FIG. 11 is a diagram for illustrating coupling a printed circuit board and a base according to an embodiment.

Content of FIG. 11 may be referred to by the contents of FIG. 1 through FIG. 10. The same term is used for the same or substantially the same configuration as described above.

Referring to FIG. 11, a printed circuit board 750 according to an embodiment may include a plurality of first regions. For example, referring to FIG. 11, the printed circuit board 750 may include the first region including a second surface 750B, and the first region including a fourth surface 750D. The second surface 750B and the fourth surface 750D may face a first surface (e.g., the first surface 450A of FIG. 6) of the printed circuit board 750.

According to an embodiment, the surface facing the first direction (e.g., the -z direction of FIG. 6) of the second region may protrude further in the first direction than the surface facing the first direction of the first region. For example, the third surface 750C of the second region may protrude further in the first direction than the second surface 750B and the fourth surface 750D.

According to an embodiment, lengths from the surface facing the first direction of each of the plurality of the first regions to the surface facing the first direction of the second region may differ from each other. For example, the length from the second surface 750B to the third surface 750C may be different from the length from the fourth surface 750D to the third surface 750C. However, it is not limited thereto. For example, at least two or more of the lengths from the surface facing the first direction of each of the plurality of the first regions to the surface facing the first direction of the second region may be the same.

According to an embodiment, the length from the surface facing the first direction in each of the plurality of the first regions to the surface facing the first direction in the second region may vary depending on at least one element 790 disposed on the surface facing the first direction in each of the plurality of the first regions. For example, the length from the surface facing the first direction in each of the plurality of the first regions to the surface facing the first direction in the second region may vary depending on the first direction thickness of the at least one element 790.

According to an embodiment, a plurality of pads 731 and 732 may be disposed on the surface facing the first direction of the first region. For example, referring to FIG. 11, the plurality of the first pads 731 may be disposed on the second surface 750B, and the plurality of the second pads 732 may be disposed on the fourth surface 750D.

According to an embodiment, the electrical element 790 may be disposed on the plurality of the pads 731 and 732. For example, the electrical element 790 may contact the plurality of the pads 731 and 732.

According to an embodiment, a base 740 may be disposed on the third surface 750C of the second region. For example, the base 740 may contact the third surface 750C of the second region. In an example, the shape of the base 740 may correspond to the shape of the second region. However, it is not limited thereto.

According to an embodiment, at least a part of the printed circuit board 750 and an image sensor 760 may be disposed on the base 740. For example, at least a part of the printed circuit board 750 and the image sensor 760 may be bonded to the base 740.

According to an embodiment, the base 740 may be bonded to the second region. For example, the base 740 may be bonded to the third surface 750C of the second region. For example, the base 740 may be bonded to the third surface 750C using at least one adhesive member. The at least one adhesive member may be disposed between the base 740 and the second region. For example, the at least one adhesive member may be disposed between the base 740 and the third surface 750C. In an example, the at least one adhesive member may include at least one of an adhesive tape, a bond, or an epoxy. However, it is not be limited thereto.

According to an embodiment, if the base 740 is disposed on the third surface 750C of the second region, at least a part of the first region may be visually visible from the outside.

According to an embodiment, the at least one side (or, edge) (e.g., the first side 751 and/or the second side 752) of the printed circuit board 750 facing in the direction substantially perpendicular to the first direction (e.g., the x-axis direction and/or the y-axis direction) of the first region may include at least one side (or, edge) facing in a direction different from the first direction of the first region. In an example, the at least one side of the printed circuit board 750 may include at least one side facing the direction substantially perpendicular to the first direction of the first region. In an example, the at least one side of the printed circuit board 750 may include at least one side including a sloped surface which forms an incline with the first direction of the first region. In an example, the at least one side of the printed circuit board 750 may include at least one side including a rough surface of the first region. In an example, referring to FIG. 10, if the first region is formed by removing at least a part of the printed circuit board 750, at least a part of the printed circuit board 750 being removed may be removed along with an outer region (e.g., the third region R3 including at least a part of the outer region 660 of FIG. 10) of the printed circuit board 750. By removing at least a part of the printed circuit board 750 with the outer region of the printed circuit board 750, the manufacturing process of the first region and the second region of the printed circuit board 750 may be facilitated. By removing at least a part of the printed circuit board 750 along with the outer region of the printed circuit board 750, the space where the electrical element 790 is disposed (e.g., the space corresponding to the first region) may be opened in the direction of at least one side (or, edge) of the printed circuit board 750. For example, referring to the second surface 750B, the space in which the electrical element 790 is disposed (e.g., the space corresponding to the second surface 750B) may be opened to the first side 751 of the printed circuit board 750. For example, referring to the fourth surface 750D, the space in which the electrical element 790 is disposed (e.g., the space corresponding to the fourth surface 750D) may be opened to the second side 752 of the printed circuit board 750.

According to an embodiment, the first region may include a fifth surface 750E. In an example, the fifth surface 750E may form substantially the same plane as the fourth surface 750D. However, it is not limited thereto. The fifth surface 750E may be a surface formed by removing at least a part of the printed circuit board 750 removed to form the first region, along with the outer region (e.g., the third region R3, including at least a part of the outer region 660 of FIG. 10) of the printed circuit board 750.

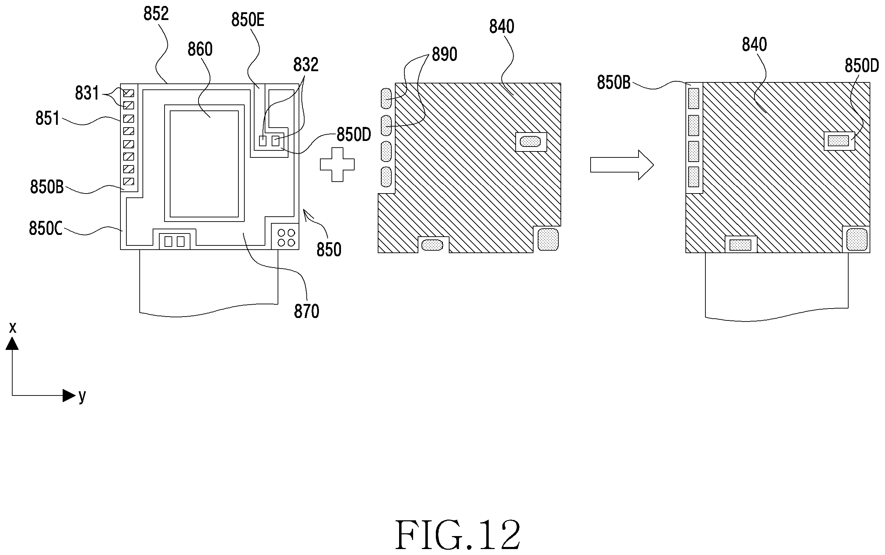

FIG. 12 is a diagram for illustrating coupling a printed circuit board and a base according to an embodiment.

Content of FIG. 12 may be referred to by the contents of FIG. 1 through FIG. 11. The same term is used for the same or substantially the same configuration as described above.

Referring to FIG. 12, a printed circuit board 850 according to an embodiment may include a plurality of first regions. For example, referring to FIG. 12, the printed circuit board 850 may include the first region including a second surface 850B, and the first region including a fourth surface 850D. The second surface 850B and the fourth surface 850D may be opposite to a first surface (e.g., the first surface 450A of FIG. 6) of the printed circuit board 850.

According to an embodiment, a surface facing the first direction (e.g., the -z direction of FIG. 6) of the second region may protrude further in the first direction than the surface facing the first direction of the first region. For example, the third surface 850C of the second region may protrude further in the first direction than the second surface 850B and the fourth surface 850D.

According to an embodiment, the length from a first direction facing surface of each of the plurality of the first regions to a first direction facing surface of a second region may differ. For example, the length from the second surface 850B to the third surface 850C may be different from the length from the fourth surface 850D to the third surface 850C. However, it is not limited thereto. For example, at least two or more of the lengths from the first direction facing surface of each of the plurality of the first regions to the first direction facing surface of the second region may be the same.

According to an embodiment, the length from the first direction facing surface of each of the plurality of the first regions to the first direction facing surface of the second region may vary depending on at least one element 890 disposed on the first direction facing surface of each of the first regions. For example, the length from the first direction facing surface of each of the plurality of the first regions to the first direction facing surface of the second region may vary depending on the first direction thickness of the at least one element 890.

According to an embodiment, a plurality of pads 831 and 832 may be disposed on the first direction facing surface of the first region. For example, referring to FIG. 12, the plurality of the first pads 831 may be disposed on the second surface 850B, and the plurality of the second pads 832 may be disposed on the fourth surface 850D.

According to an embodiment, the electrical element 890 may be disposed on the plurality of the pads 831 and 832. For example, the electrical element 890 may contact the plurality of the pads 831 and 832.

According to an embodiment, at least a part of the printed circuit board 850 and an image sensor 860 may be disposed on a base 840. For example, at least a part of the printed circuit board 850 and the image sensor 860 may be bonded to the base 840.

According to an embodiment, the base 840 may be disposed on the third surface 850C of the second region. For example, the base 840 may contact the third surface 850C of the second region. In an example, the shape of the base 840 may correspond to the shape of the second region. However, it is not limited thereto.

According to an embodiment, the base 840 may be coupled with the second region. For example, the base 840 may be coupled with the third surface 850C of the second region. For example, the base 840 may be coupled with the third surface 850C of the second region using at least one solder 870 (e.g., a solder joint, a solder fixture). The at least one solder 870 may be disposed between the base 840 and the second region. For example, the at least one solder 870 may be disposed between the base 840 and the third surface 850C. In an example, the shape of the at least one solder 870 may correspond to the shape of the second region. For example, the shape of the at least one solder 870 may correspond to the shape of the third surface 850C. However, it is not limited thereto.

According to an embodiment, if the base 840 is disposed on the third surface 850C of the second region, at least a part of the first region may be visually visible from the outside.

According to an embodiment, at least one side (or, edge) (e.g., a first side 851 and/or a second side 852) facing a direction (e.g., the x-axis direction and/or the y-axis direction) substantially perpendicular to the first direction of the printed circuit board 850 may include at least one side (or, edge) facing a direction substantially perpendicular to the first direction of the first region. For example, referring to FIG. 10, if the first region is formed by removing at least a part of the printed circuit board 850, at least a part of the printed circuit board 850 being removed may be removed along with an outer region (e.g., the third region R3 including at least a part of the outer region 660 of FIG. 10) of the printed circuit board 850. By removing at least a part of the printed circuit board 850 removed along with the outer region of the printed circuit board 850, the manufacturing process of the first region and the second region of the printed circuit board 850 may be facilitated. By removing at least a part of the removed printed circuit board 850 along with the outer region of the printed circuit board 850, the space where the electrical element 890 is disposed (e.g., the space corresponding to the first region) may be opened in the direction of at least one side (or, edge) of the printed circuit board 850. For example, referring to the second surface 850B, the space in which the electrical element 890 is disposed (e.g., the space corresponding to the second surface 850B) may be open to the first side 851 of the printed circuit board 850. For example, referring to the fourth surface 850D, the space in which the electrical element 890 is disposed (e.g., the space corresponding to the fourth surface 850D) may be opened to the second side 852 of the printed circuit board 850.

According to an embodiment, the first region may include a fifth surface 850E. In an example, the fifth surface 850E may form substantially the same plane as the fourth surface 850D. However, it is not limited thereto. The fifth surface 850E may be a surface formed by removing at least a part of the printed circuit board 850 removed to form the first region along with an outer region of the printed circuit board 850.

According to an embodiment, if the base 840 is disposed on the printed circuit board 850, the fifth surface 850E may be bonded to the base 840. For example, at least one adhesive member may be disposed between the fifth surface 850E and the base 840. For example, the at least one adhesive member may include at least one of an adhesive tape, a bond, or an epoxy. In an example, if the base 840 is disposed on the printed circuit board 850, the adhesive member may fill the space formed by the fifth surface 850E, the second region and the base 840. However, it is not limited thereto. For example, if the base 840 is disposed on the printed circuit board 850, at least a part of the space formed by the fifth surface 850E, the second region and the base 840 may form a hollow space.

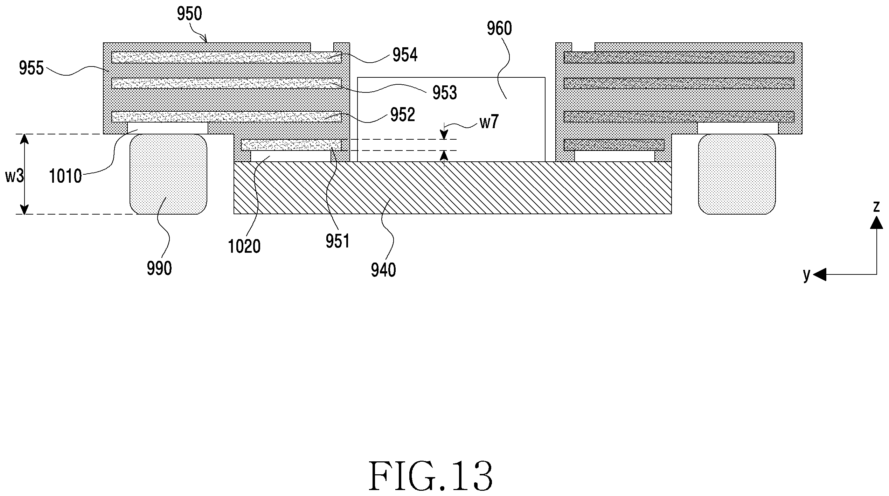

FIG. 13 is a diagram for illustrating a printed circuit board and a base being coupled according to an embodiment.

Content of FIG. 13 may be referred to by the contents of FIG. 1 through FIG. 12. The same term is used for the same or substantially the same configuration as described above.

A printed circuit board 950 according to an embodiment may include a plurality of circuit layers. For example, referring to FIG. 13, the printed circuit board 950 may include a first circuit layer 951, a second circuit layer 952, a third circuit layer 953 and a fourth circuit layer 954. However, it is not limited thereto. For example, the printed circuit board 950 may omit at least one circuit layer mentioned above, or may further include at least one circuit layer.

According to an embodiment, the printed circuit board 950 may include a plurality of insulation layers 955 disposed between the plurality of the circuit layers. For example, the insulation layer 955 may be disposed between the first circuit layer 951 and the second circuit layer 952. For example, the insulation layer 955 may be disposed between the second circuit layer 952 and the third circuit layer 953. For example, the insulation layer 955 may be disposed between the third circuit layer 953 and the fourth circuit layer 954. In an example, the insulation layer 955 may at least in part surround at least one circuit layer of the plurality of the circuit layers.

According to an embodiment, the plurality of the circuit layers 951, 952, 953, and 954 of the printed circuit board 950 may overlap at least in part in the first direction (e.g., the z-direction or the -z-direction). At least two or more of the plurality of the circuit layers 951, 952, 953, and 954 of the printed circuit board 950 may overlap in the first direction.

According to an embodiment, an electrical element 990 may have a third thickness w3 in the first direction. At least one circuit layer of the plurality of the circuit layers 951, 952, 953, and 954 may have a fifth thickness w7 in the first direction. In an example, the fifth thickness w7 may be smaller than, or equal to the third thickness w3. However, it is not limited thereto.

According to an embodiment, the printed circuit board 950 may be connected to the electrical element 990. For example, at least one circuit layer of the plurality of the circuit layers 951, 952, 953, the 954 may be connected to the electrical element 990. For example, referring to FIG. 13, the second circuit layer 952 may be connected to the electrical element 990.

According to an embodiment, the camera module may include at least one of at least one first solder 1010 disposed to bond the electrical element 990 to the first region, or at least one second solder 1020 disposed to bond a base 940 to the second region.

According to an embodiment, at least one solder may be disposed between at least one circuit layer of the plurality of the circuit layers 951, 952, 953, and 954 and the electrical element 990. For example, referring to FIG. 13, the at least one first solder 1010 may be disposed between the second circuit layer 952 and the electrical element 990. The electrical element 990 may be connected to the at least one circuit layer via at least one solder (e.g., the first solder 1010).

According to an embodiment, at least one solder may be disposed between at least one circuit layer of the plurality of the circuit layers 951, 952, 953, and 954 and the base 940. For example, referring to FIG. 13, the at least one second solder 1020 may be disposed between the first circuit layer 951 and the base 940. The base 940 may be connected to the printed circuit board 950 via at least one solder (e.g., the second solder 1020).

According to an embodiment, an image sensor 960 may be disposed on the base 940. For example, the image sensor 960 may be disposed on a top surface (e.g., a surface facing the +z direction) of the base 940. In an example, the image sensor 960 may be disposed on at least a part of the top surface of the base 940, and the printed circuit board 950 (e.g., the second region) may be disposed on the remaining portion.

According to an embodiment, a circuit layer (e.g., the first circuit layer 951) adjacent to the base 940 among the plurality of the circuit layers 951, 952, 953, and 954 of the printed circuit board 950, may include a pattern related to the image sensor 960. For example, the first circuit layer 951 may include at least one of a pattern related to powering of the image sensor 960, a ground pattern or a signal pattern. However, it is not limited thereto. In an example, the first circuit layer 951 may include at least one pad disposed to connect with the base 940. For example, the first circuit layer 951 may include at least one ground pad.

According to an embodiment, a circuit layer (e.g., the second circuit layer 952) adjacent to the electrical element 990 among the plurality of the circuit layers 951, 952, 953, and 954 of the printed circuit board 950 may include at least one pad disposed to be connected to the electrical element 990 related to the image sensor 960. The electrical element 990 may be connected with the image sensor 960. In an example, the electrical element 990 may include at least one of an IC, a capacitor or a resistor chip. However, it is not limited thereto.

According to an embodiment, a circuit layer (e.g., the fourth circuit layer 954) adjacent to the top surface (e.g., a surface facing the +z direction) of the printed circuit board 950 among the plurality of the circuit layers 951, 952, 953, and 954 of the printed circuit board 950, may include at least one of at least one pad disposed to connect with the image sensor 960, or at least one pad disposed to connect with an actuator (e.g., the first driving unit 270 and/or the second driving unit 280 of FIG. 4) of the camera module. However, it is not limited thereto.

According to an embodiment, among the plurality of the circuit layers 951, 952, 953, and 954 of the printed circuit board 950, at least one circuit layer (e.g., the third circuit layer 953) disposed between a circuit layer (e.g., the fourth circuit layer 954) adjacent to the top surface (e.g., the surface facing in the +z direction) of the printed circuit board 950 and a circuit layer (e.g., the second circuit layer 952) adjacent to the electrical element 990 may include at least one of a pattern related to the powering of the image sensor 960, a ground pattern, or a signal pattern. However, it is not limited thereto.

According to an embodiment, at least one circuit layer of the plurality of the circuit layers 951, 952, 953, and 954 may include a metal. For example, the at least one circuit layer of the plurality of the circuit layers 951, 952, 953, and 954 may include copper. However, it is not limited thereto.

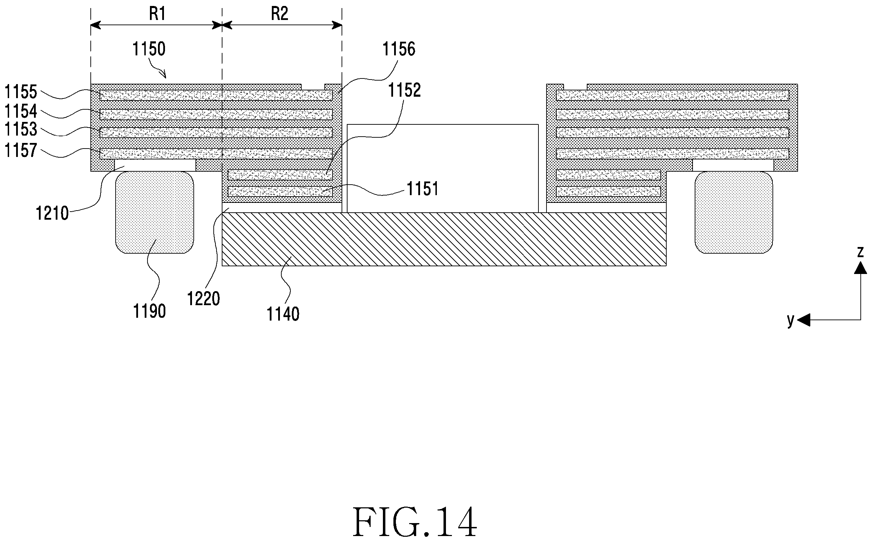

FIG. 14 is a diagram for illustrating a printed circuit board and a base being coupled according to an embodiment.

Content of FIG. 14 may be referred to by the contents of FIG. 1 through FIG. 13. The same term is used for the same or substantially the same configuration described above.

Referring to FIG. 14, a printed circuit board 1150 according to an embodiment may include a plurality of circuit layers. For example, the printed circuit board 1150 may include a first circuit layer 1151, a second circuit layer 1152, a third circuit layer 1153, a fourth circuit layer 1154 and a fifth circuit layer 1155. However, the circuit layers included on the printed circuit board 1150 are not limited thereto. For example, the printed circuit board 1150 may omit at least one of the circuit layers mentioned above, or may further include at least one circuit layer.

According to an embodiment, the printed circuit board 1150 may include a plurality of insulation layers 1156 disposed between the plurality of the circuit layers 1151, 1152, 1153, 1154, 1155, and 1157. For example, the insulation layer 1156 may be disposed between the first circuit layer 1151 and the second circuit layer 1152. For example, the insulation layer 1156 may be disposed between the second circuit layer 1152 and the third circuit layer 1153. For example, the insulation layer 1156 may be disposed between the second circuit layer 1152 and the sixth circuit layer 1157. For example, the insulation layer 1156 may be disposed between the sixth circuit layer 1157 and the third circuit layer 1153. For example, the insulation layer 1156 may be disposed between the third circuit layer 1153 and the fourth circuit layer 1154. For example, the insulation layer 1156 may be disposed between the fourth circuit layer 1154 and the fifth circuit layer 1155. In an example, the insulation layer 1156 may at least in part surround at least one circuit layer of the plurality of the circuit layers 1151, 1152, 1153, 1154, 1155, and 1157.

According to an embodiment, at least one circuit layer of the plurality of the circuit layers 1151, 1152, 1153, 1154, 1155, and 1157 may be disposed in the second region R2. For example, the first circuit layer 1151 and the second circuit layer 1152 may be disposed in the second region R2. At least one circuit layer of the plurality of the circuit layers 1151, 1152, 1153, 1154, 1155, and 1157 may be disposed in the first region R1 and the second region R2. For example, the third circuit layer 1153, the fourth circuit layer 1154, and the fifth circuit layer 1155 may be disposed in the first region R1 and the second region R2. For example, at least a part of at least one circuit layer (the third circuit layer 1153, the fourth circuit layer 1154, and the fifth circuit layer 1155) of the plurality of the circuit layers 1151, 1152, 1153, 1154, 1155, and 1157 may be disposed in the first region R1, and a remaining part may be disposed in the second region R2.

According to an embodiment, the number of the circuit layers disposed in the first region R1 may be smaller than or equal to the number of the circuit layers disposed in the second region R2. For example, referring to FIG. 14, the third circuit layer 1153, the fourth circuit layer 1154, and the fifth circuit layer 1155 may be disposed in the first region R1, and the first circuit layer 1151 and the second circuit layer 1152 may be disposed more in the second region R1 than the first region R1.

According to an embodiment, at least one solder 1210 may be disposed between at least one circuit layer (e.g., the third circuit layer 1153) of the plurality of the circuit layers 1151, 1152, 1153, 1154, 1155, and 1157 and an electrical element 1190. The electrical element 1190 may be connected to the at least one circuit layer via the at least one solder 1210.

According to an embodiment, at least one adhesive member 1220 may be disposed between at least one circuit layer (e.g., the first circuit layer 1151) of the plurality of the circuit layers 1151, 1152, 1153, 1154, 1155, and 1157 and the base 1140. For example, referring to FIG. 14, the at least one adhesive member 1220 may be disposed between the first circuit layer 1151 and the base 1140. The base 1140 may be connected to the printed circuit board 1150 through the at least one adhesive member 1220.

According to an embodiment, the at least one adhesive member 1220 may include at least one of an adhesive tape, a bond, or an epoxy. However, it is not limited thereto.

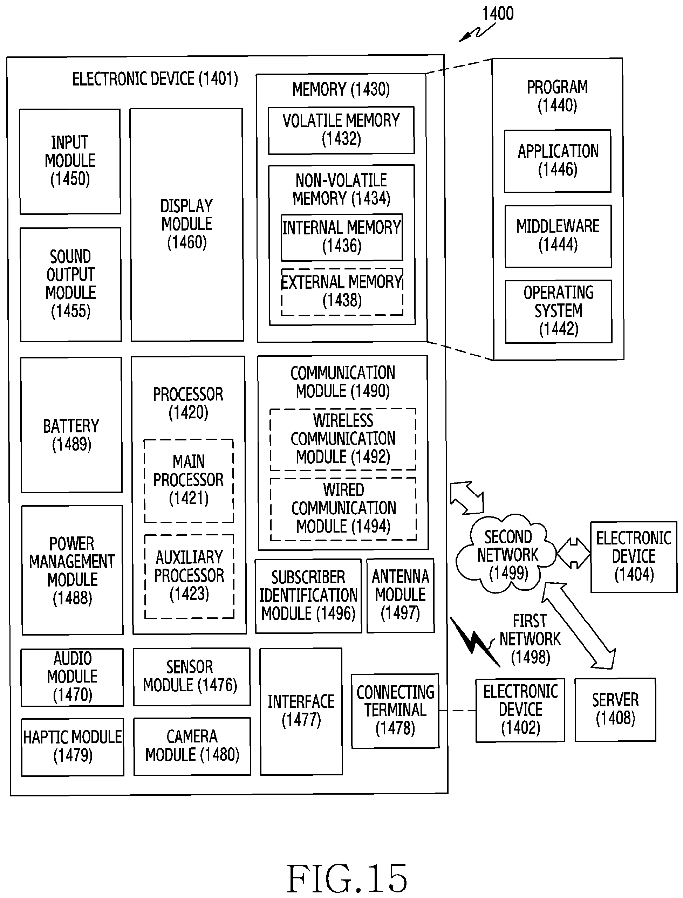

Hereafter, an apparatus to which the various embodiments disclosed herein may be applied or expanded is specified and expanded by referring to FIG. 15 and FIG. 16.

FIG. 15 is a block diagram of an electronic device 1401 in a network environment 1400, according to various embodiments.

Referring to FIG. 15, the electronic device 1401 in the network environment 1400 may communicate with an electronic device 1402 over a first network 1498 (e.g., a short-range wireless communication network), or may communicate with at least one of an electronic device 1404 or a server 1408 over a second network 1499 (e.g., a long-range wireless communication network). According to an embodiment, the electronic device 1401 may communicate with the electronic device 1404 via the server 1408. According to an embodiment, the electronic device 1401 may include a processor 1420, a memory 1430, an input module 1450, an audio output module 1455, a display module 1460, an audio module 1470, a sensor module 1476, an interface 1477, a connection terminal 1478, a haptic module 1479, a camera module 1480, a power management module 1488, a battery 1489, a communication module 1490, a subscriber identification module 1496, or an antenna module 1497. In an embodiment, at least one (e.g., the connection terminal 1478) of the components may be omitted, or one or more other components may be added in the electronic device 1401. In an embodiment, some (e.g., the sensor module 1476, the camera module 1480, or the antenna module 1497) of the components may be integrated into a single component (e.g., the display module 1460).

The processor 1420 may, for example, execute software (e.g., a program 1440) to thus control at least one other component (e.g., a hardware or software component) of the electronic device 1401 coupled to the processor 1420, and perform various data processing or computations. According to an embodiment, as at least a part of the data processing or computation, the processor 1420 may store a command or data received from other component (e.g., the sensor module 1476 or the communication module 1490) in a volatile memory 1432, process the command or the data stored in the volatile memory 1432, and store resulting data in a non-volatile memory 1434. According to an embodiment, the processor 1420 may include a main processor 1421 (e.g., a central processing device or an application processor) or an auxiliary processor 1423 (e.g., a graphics processing device, a neural processing portion (NPU), an image signal processor, a sensor hub processor, or a communication processor) for operating independently from or in conjunction with it. For example, if the electronic device 1401 includes the main processor 1421 and the auxiliary processor 1423, the auxiliary processor 1423 may be configured to use lower power than the main processor 1421, or to be specific for a designated function. The auxiliary processor 1423 may be implemented as separately from, or as a part of the main processor 1421.

The auxiliary processor 1423 may control at least some of functions or states related to at least one component (e.g., the display module 1460, the sensor module 1476, or the communication module 1490) of the components of the electronic device 1401, for example, instead of the main processor 1421 while the main processor 1421 is in an inactive (e.g., sleeping) state, or together with the main processor 1421 while the main processor 1421 is in an active state (e.g., executing an application). According to an embodiment, the auxiliary processor 1423 (e.g., an image signaling processor or a communication processor) may be implemented as a part of other component (e.g., the camera module 1480 or the communication module 1490) functionally related. According to an embodiment, the auxiliary processor 1423 (e.g., the NPU) may include a hardware structure specified for artificial intelligence model processing. An artificial intelligence model may be generated through machine learning. Such learning may be performed, for example, by the electronic device 1401 where the artificial intelligence is conducted, or via a separate server (e.g., the server 1408). A learning algorithm may include, but not limited to, for example, supervised learning, unsupervised learning, semi-supervised learning or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-networks or a combination of two or more of them, but is not limited thereto. The artificial intelligence model may, additionally or alternatively, include a software structure, in addition to the hardware structure.

The memory 1430 may store various data used by at least one component (e.g., the processor 1420 or the sensor module 1476) of the electronic device 1401. The data may include, for example, software (e.g., the program 1440), and input data or output data for a command related thereto. The memory 1430 may include the volatile memory 1432 or the non-volatile memory 1434.

The program 1440 may be stored as software in the memory 1430, and may include, for example, an operating system 1442, middleware 1444 or an application 1446.

The input module 1450 may receive a command or data to be used by the component (e.g., the processor 1420) of the electronic device 1401 from outside (e.g., a user) of the electronic device 1401. The input module 1450 may include, for example, a microphone, a mouse, a keyboard, a key (e.g., a button), or a digital pen (e.g., a stylus pen).

The audio output module 1455 may output a sound signal to the outside of the electronic device 1401. The audio output module 1455 may include, for example, a speaker or a receiver. The speaker may be used for a general use such as multimedia playing or record playing. The receiver may be used to receive an incoming call. According to an embodiment, the receiver may be implemented separately from, or as a part of the speaker.

The display module 1460 may visually provide information to the outside (e.g., the user) of the electronic device 1401. The display module 1460 may include, for example, a display, a hologram device, or a projector and control circuitry for controlling a corresponding device. According to an embodiment, the display module 1460 may include a touch sensor configured to detect a touch, or a pressure sensor configured to measure an intensity of a force generated by the touch.

The audio module 1470 may convert a sound into an electrical signal, or convert an electrical signal into a sound. According to an embodiment, the audio module 1470 may obtain the sound via the input module 1450, or output the sound via the audio output module 1455, or an external electronic device (e.g., the electronic device 1402) (e.g., a speaker or a headphone) directly or wirelessly connected with the electronic device 1401.

The sensor module 1476 may detect an operation state (e.g., a power or a temperature) of the electronic device 1401, or an external environment state (e.g., a user state), and generate an electrical signal or a data value corresponding to the detected state. According to an embodiment, the sensor module 1476 may include, for example, a gesture sensor, a gyro sensor, a barometric sensor, a magnetic sensor, an acceleration sensor, a grip sensor, a proximity sensor, a color sensor, an IR sensor, a biosensor, a temperature sensor, a humidity sensor, or an illuminance sensor.

The interface 1477 may support one or more designated protocols to be used for the electronic device 1401 to connect with the external electronic device (e.g., the electronic device 1402) directly or wirelessly. According to an embodiment, the interface 1477 may include, for example, a high definition multimedia interface (HDMI), a universal serial bus (USB) interface, a secure digital (SD) card interface, or an audio interface.

The connection terminal 1478 may include a connector for physically connecting the electronic device 1401 with the external electronic device (e.g., the electronic device 1402). According to an embodiment, the connection terminal 1478 may include, for example, an HDMI connector, a USB connector, an SD card connector, or an audio connector (e.g., a headphone connector).

The haptic module 1479 may convert an electrical signal into a mechanical stimulus (e.g., a vibration or a motion) or an electrical stimulus to be recognized by the user through tactile sensation or kinesthetic sensation. According to an embodiment, the haptic module 1479 may include, for example, a motor, a piezoelectric element, or an electric stimulator.

The camera module 1480 may capture a still image or moving images. According to an embodiment, the camera module 1480 may include one or more lenses, image sensors, image signal processors, or flashes.

The power management module 1488 may manage power supplied to the electronic device 1401. According to an embodiment, the power management module 1488 may be implemented as at least a part of, for example, a power management integrated circuit (PMIC).

The battery 1489 may supply the power to at least one component of the electronic device 1401. According to an embodiment, the battery 1489 may include, for example, a primary cell which is not rechargeable, a secondary cell which is rechargeable or a fuel cell.

The communication module 1490 may support establishment of a direct (e.g., wired) communication channel or a wireless communication channel between the electronic device 1401 and the external electronic device (e.g., the electronic device 1402, the electronic device 1404, or the server 1408), and communication over the established communication channel. The communication module 1490 may include one or more communication processors operated independently from the processor 1420 (e.g., the application processor), and supporting the direct (e.g., wired) communication or the wireless communication. According to an embodiment, the communication module 1490 may include a wireless communication module 1492 (e.g., a cellular communication module, a short-range wireless communication module, or a GNSS communication module) or a wired communication module 1494 (e.g., a local region network (LAN) communication module, or a power line communication module). A corresponding communication module of these communication modules may communicate with the external electronic device 1404 via the first network 1498 (e.g., a short-range communication network such as Bluetooth, wireless-fidelity (Wi-Fi) direct, or infrared data association (IrDA)) or the second network 1499 (e.g., a long-range communication network such as a legacy cellular network, a 5th (5G) network, a next-generation communication network, Internet, or a computer network (e.g., a LAN or a wide area network (WAN)). These various communication modules may be integrated as a single component (e.g., a single chip), or may be implemented as a plurality of separate components (e.g., multiple chips). The wireless communication module 1492 may identify and authenticate the electronic device 1401 in the communication network such as the first network 1498 or the second network 1499 using subscriber information (e.g., international mobile subscriber identity (IMSI)) stored in the subscriber identification module 1496.

The wireless communication module 1492 may support a 5G network after a 4G network and a next-generation communication technology, for example, a new radio (NR) access technology. The NR access technology may support high-speed transmission of high-capacity data (enhanced mobile broadband (eMBB)), minimization of terminal power and connection of multiple terminals (massive machine type communications (mMTC)), or high reliability and low latency (ultra-reliable and low-latency communications (URLLC)). The wireless communication module 1492 may support, for example, a high-frequency band (e.g., millimeter waves (mmWave) band), to achieve a high data transmission rate. The wireless communication module 1492 may support various technologies for securing performance in the high-frequency band, for example, techniques such as beamforming, massive multiple-input and multiple-output (MIMO), full dimensional (FD)-MIMO, an array antenna, analog beamforming, or a large scale antenna. The wireless communication module 1492 may support various requirements specified in the electronic device 1401, the external electronic device (e.g., the electronic device 1404), or a network system (e.g., the second network 1499). According to an embodiment, the wireless communication module 1492 may support a peak data rate (e.g., 20 Gbps or more) for realizing the eMBB, loss coverage (e.g., 164 dB or smaller) for realizing the mMTC, or U-plane latency (e.g., 0.5 ms or smaller for each of downlink (DL) and uplink (UL), or 1 ms or smaller for round trip) for realizing the URLLC.

The antenna module 1497 may transmit or receive a signal or power to or from the outside (e.g., the external electronic device). According to an embodiment, the antenna module 1497 may include an antenna including a radiator formed of a conductor or a conductive pattern formed on a substrate (e.g., a printed circuit board (PCB)). According to an embodiment, the antenna module 1497 may include a plurality of antennas (e.g., array antennas). In this case, at least one antenna appropriate for a communication scheme used in the communication network such as the first network 1498 or the second network 1499 may be selected, for example, by the communication module 1490 from the plurality of the antennas. The signal or the power may be transmitted or received between the communication module 1490 and the external electronic device via the at least one antenna selected. According to some embodiment, other component (e.g., a radio frequency integrated circuit (RFIC)) than the radiator may be additionally formed as a part of the antenna module 1497.

According to various embodiments, the antenna module 1497 may form an mmWave antenna module. According to an embodiment, the mmWave antenna module may include a PCB, an RFIC disposed on or adjacent to a first surface (e.g., a bottom surface) of the PCB and supporting a designated high frequency band (e.g., the mmWave band), and a plurality of antennas (e.g., array antennas) disposed on or adjacent to a second surface (e.g., a top surface or a side surface) of the PCB and transmitting or receiving signals of the designated high frequency band.

At least some of the components may be connected to each other through an inter-peripheral communication scheme (e.g., a bus, general purpose input and output (GPIO), serial peripheral interface (SPI), or mobile industry processor interface (MIPI)) and exchange signals (e.g., commands or data) therebetween.

According to an embodiment, a command or data may be transmitted or received between the electronic device 1401 and the external electronic device 1404 via the server 1408 connected to the second network 1499. The external electronic device 1402 or 1404 may be a device of the same or different type as or from the electronic device 1401. According to an embodiment, all or some of operations executed at the electronic device 1401 may be carried out at one or more of the external electronic devices 1402, 1404, or 1408. For example, if the electronic device 1401 needs to perform a function or a service automatically, or in response to a request from the user or other device, the electronic device 1401 may request one or more external electronic devices to perform at least a part of the function or the service, instead of or in addition to executing the function or the service. The one or more external electronic devices receiving the request may perform at least a part of the function or the service requested, or an additional function or service related to the request, and provide a result of the execution to the electronic device 1401. The electronic device 1401 may provide the result as at least a part of a response to the request, without or with further processing of the result. For doing so, for example, cloud computing, distributed computing, mobile edge computing (MEC), or client-server computing technology may be used. The electronic device 1401 may provide an ultra-low delay service using, for example, the distributed computing or the MEC. In an embodiment, the external electronic device 1404 may include an Internet of things (IoT) device. The server 1408 may be an intelligent server using the machine learning and/or a neural network. According to an embodiment, the external electronic device 1404 or the server 1408 may be included in the second network 1499. The electronic device 1401 may be applied to an intelligent service (e.g., smart home, smart city, smart car, or healthcare) based on a 5G communication technology and an IoT-related technology.

The electronic device according to various embodiments disclosed in the disclosure may be a device of various types. The electronic device may include, for example, a portable communication device (e.g., a smartphone), a computer device, a portable multimedia device, a portable medical device, a camera, a wearable device, or a home appliance. The electronic device according to an embodiment of the disclosure is not limited to the devices described above.

It should be appreciated that various embodiments of the disclosure and the terms used therein are not intended to limit technological features disclosed in this document to particular embodiments, and embrace various modifications, equivalents, or alternatives of a corresponding embodiment. With respect to the descriptions of the drawings, similar reference numerals may be used for similar or related elements. A singular form of a noun corresponding to an item may include one or more of the items, unless the relevant context clearly indicates otherwise. As used herein, each of such phrases as "A or B", "at least one of A and B", "at least one of A or B", "A, B, or C", "at least one of A, B, and C", and "at least one of A, B, or C", may include one, or all possible combinations of the items enumerated together in a corresponding one of the phrases. Such terms as "1st" and "2nd", or "first" and "second" may be used to simply distinguish a corresponding component from another, and do not limit the corresponding components in other aspect (e.g., importance or order). If an element (e.g., a first element) is referred to, with or without the term "operatively" or "communicatively", as "coupled" or "connected" to another element (e.g., a second element), it means that the element may be coupled with the other element directly (e.g., wiredly), wirelessly, or via a third element.

The term "module" used in various embodiments of the disclosure may include a unit implemented in hardware, software or firmware, and may be interchangeably used with a term, for example, logic, a logic block, a part, or circuitry. The module may be a single integral component, or a minimum unit or part thereof, for performing one or more functions. For example, according to an embodiment, the module may be implemented in a form of an application-specific integrated circuit (ASIC).

Various embodiments of the disclosure may be implemented as software (e.g., the program 1440) including one or more instructions which are stored in a storage medium (e.g., the internal memory 1436 or the external memory 1438) readable by a machine (e.g., the electronic device 1401). For example, a processor (e.g., the processor 1420) of the machine (e.g., the electronic device 1401) may invoke at least one of the one or more instructions stored in the storage medium, and execute it or them. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, 'non-transitory' simply means that the storage medium is a tangible device, and does not include a signal (e.g., an electromagnetic wave), but this term does not differentiate between a case where data is semi-permanently stored in the storage medium and a case where the data is temporarily stored.

According to an embodiment, a method according to various embodiments of the disclosure may be included and provided in a computer program product. The computer program product may be traded as a product between a seller and a buyer. The computer program product may be distributed in the form of a machine-readable storage medium (e.g., a compact disc read only memory (CD-ROM)), or may be distributed (e.g., downloaded or uploaded) directly or online via an application store (e.g., Play Store^{™}) or between two user devices (e.g., smart phones). In the online distribution, at least a part of the computer program product may be temporarily stored in the machine-readable storage medium such as a memory of a manufacturer's server, an application store server, or a relay server, or may be temporarily generated.

According to various embodiments, each component (e.g., a module or a program) of the above-described components may include a single entity or multiple entities, and some of the multiple entities may be separately deployed in different components. According to various embodiments, one or more components or operations of the above-described components may be omitted, or one or more other components or operations may be added. Alternatively or additionally, a plurality of components (e.g., modules or programs) may be integrated as a single component. In this case, the integrated component may perform one or more functions of each component of the plurality of the components in the same or similar manner as they are performed by a corresponding component of the plurality of the components before the integration. According to various embodiments, operations performed by the module, the program or other component may be carried out sequentially, in parallel, repeatedly, or heuristically, one or more of the operations may be executed in a different order or omitted, or one or more other operations may be added.

FIG. 16 is a block diagram 1500 illustrating a camera module 1480, according to various embodiments.

Referring to FIG. 16, the camera module 1480 may include a lens assembly 1510, a flash 1520, an image sensor 1530, an image stabilizer 1540, a memory 1550 (e.g., a buffer memory), or an image signal processor 1560. The lens assembly 1510 may collect light emitted from a subject to be captured for an image. The lens assembly 1510 may include one or more lenses. According to an embodiment, the camera module 1480 may include a plurality of lens assemblies 1510. In this case, the camera module 1480 may form, for example, a dual camera, a 360-degree camera, or a spherical camera. Some of the plurality of the lens assemblies 1510 may have the same lens properties (e.g., an angle of view, a focal length, autofocus, an f number, or optical zoom), or at least one lens assembly may have one or more lens properties different from the lens properties of the other lens assemblies. The lens assembly 1510 may include, for example, a wide-angle lens or a telephoto lens.

The flash 1520 may emit light used to enhance the light emitted or reflected from the subject. According to an embodiment, the flash 1520 may include one or more light emitting diodes (e.g., a red-green-blue (RGB) LED, a white LED, an infrared LED, or an ultraviolet LED), or a xenon lamp. The image sensor 1530 may convert the light emitted or reflected from the subject and transmitted through the lens assembly 1510 into an electrical signal, and thus acquire an image corresponding to the subject. According to an embodiment, the image sensor 1530 may include one image sensor selected from image sensors having different properties, for example, an RGB sensor, a black and white (BW) sensor, an IR sensor, or an ultraviolet (UV) sensor, a plurality of image sensors having the same properties, or a plurality of image sensors having different properties. The image sensors included in the image sensor 1530 each may be implemented using, for example, a charged coupled device (CCD) sensor or a complementary metal oxide semiconductor (CMOS) sensor.

The image stabilizer 1540 may, in response to a movement of the camera module 1480 or the electronic device (e.g., the electronic device 1401 of FIG. 15) including the same, move at least one lens or the image sensor 1530 included in the lens assembly in a specific direction or control an operational attribute of the image sensor 1530 (e.g., adjust a read-out timing). This allows to compensate for at least a part of a negative effect by the movement on the captured image. According to an embodiment, the image stabilizer 1540 may detect such a movement of the camera module 1480 or the electronic device 1401 using a gyro sensor (not shown) or an acceleration sensor (not shown) disposed inside or outside the camera module 1480, according to an embodiment. According to an embodiment, the image stabilizer 1540 may be implemented with, for example, an optical image stabilizer. The memory 1550 may at least temporarily store at least a part of the image obtained through the image sensor 1530 for a subsequent image processing task. For example, if the image acquisition is delayed due to shutter lag or multiple images are captured quickly, a raw image acquired (e.g., a Bayer-patterned image or a high-resolution image) may be stored in the memory, and its corresponding copy image (e.g., a low-resolution image) may be previewed through a display device (e.g., the display module 1460). Next, if a designated condition is satisfied (e.g., a user input or a system command), at least a part of the raw image stored in the memory 1550 may be obtained and processed, for example, by the image signal processor 1560. According to an embodiment, the memory 1550 may be configured as at least a part of the memory 1550, or as a separate memory operated independently.

The image signal processor 1560 may perform one or more image processing on an image obtained through the image sensor 1530 or an image stored in the memory 1550. The one or more image processing may include, for example, depth map generation, 3D modeling, panorama generation, feature point extraction, image synthesizing, or image compensation (e.g., noise reduction, resolution adjustment, brightness adjustment, blurring, sharpening, or softening). Additionally or alternatively, the image signal processor 1560 may control (e.g., control exposure time, or control read-out timing) at least one (e.g., the image sensor 1530) of the components included in the camera module 1480. The image processed by the image signal processor 1560 may be stored back in the memory 1550 for further processing, or may be provided to an external component (e.g., the memory 1430, the display module 1460, the electronic device 1402, the electronic device 1404, or the server 1408 of FIG. 15) of the camera module 1480. According to an embodiment, the image signal processor 1560 may be configured as at least a part of the processor 1420 of FIG. 15, or as a separate processor operated independently from the processor 1420. If the image signal processor 1560 is configured as the separate processor from the processor 1420, at least one image processed by the image signal processor 1560 may be displayed on the display module 1460 as it is or after further image processing by the processor 1420.

According to an embodiment, the electronic device 1401 may include a plurality of camera modules 1480 each having different properties or capabilities. In this case, for example, at least one of the plurality of the camera modules 1480 may be a wide-angle camera, and at least another one may be a telephoto camera. Similarly, at least one of the plurality of the camera modules 1480 may be a front camera, and at least another one may be a rear camera.

The technical problems to be achieved by the disclosure are not limited to the technical problems mentioned above, and other technical problems not mentioned may be clearly understood by those skilled in the art of the technical field which the disclosure belongs to.

As set forth above, a camera module (e.g., the camera module 200 of FIG. 4) according to an embodiment may include a housing (e.g., the housing 220 of FIG. 4), a lens assembly (e.g., the lens assembly 210 of FIG. 4) disposed at least in part inside the housing, and including at least one lens, an image sensor (e.g., the image sensor 260 of FIG. 4) for converting light received through the at least one lens into an electrical signal, a printed circuit board (e.g., the printed circuit board 250 of FIG. 4) including a first surface on which the lens assembly is disposed, a base (e.g., the base 240 of FIG. 4) on which the printed circuit board is disposed, and at least one electrical element (e.g., the electrical element 290 of FIG. 4) connected to the printed circuit board. The printed circuit board may include a first region (e.g., the first region 250A of FIG. 4) having a thickness (e.g., the first thickness w1 of FIG. 6) of a first length in a first direction from the first surface to the base in the housing, and a second region (e.g., the second region 250B of FIG. 4) having a thickness (e.g., the second thickness w2 of FIG. 6) of a second length which is greater than the first length from the first surface in the first direction. The first region may include a second surface facing the first surface. The at least one electrical element may be disposed on the second surface.

According to an embodiment, the electrical element may be disposed to overlap with the first region in the first direction, and the base may be disposed to overlap with the second region in the first direction.

According to an embodiment, the electrical element may have a thickness (e.g., the third thickness w3 of FIG. 6) of a third length in the first direction. A sum of the first length and the third length may be smaller than or equal to a fourth length (e.g., the fourth thickness w4 of FIG. 6) which is a length from the first surface of the printed circuit board to a reference plane on which the base is disposed in the first direction.

According to an embodiment, the at least one side of the printed circuit board facing a direction substantially perpendicular to the first direction may include at least one side of the first region facing a direction substantially perpendicular to the first direction.

According to embodiment, the at least one electrical element may be disposed to overlap with at least a part of the second region and the base in a direction substantially perpendicular to the first direction.

According to an embodiment, the printed circuit board may include a plurality of circuit layers (e.g., the circuit layers 951, 952, 953, and 954) at least in part overlapping each other in the first direction. The number of circuit layers disposed in the first region may be smaller than the number of circuit layers disposed in the second region.

According to an embodiment, the electronic device may include at least one of at least one first solder (e.g., the first solder 1010 of FIG. 13) disposed to bond the at least one electrical element to the first region, or at least one second solder (e.g., the second solder 1020 of FIG. 13) disposed to bond the base to the second region.

According to an embodiment, the electronic device may include at least one adhesive member (e.g., the adhesive member 1220 of FIG. 14) disposed between the second region and the base. The adhesive member may include at least one of an adhesive tape, a bond, or an epoxy.

According to an embodiment, the lens assembly may be disposed to move based on the housing. The camera module may further include a first driving unit disposed inside the housing, and moving the lens assembly in the first direction based on the housing. The first driving unit may include a first carrier for carrying the lens assembly in the first direction, and at least one first sphere disposed between the first carrier and the housing and disposed to move the first carrier in the first direction with respect to the housing. The first carrier may include at least one first guide portion for guiding the at least one first sphere to move in the first direction.

According to an embodiment, the first driving unit may include a first magnet disposed on the first side of the first carrier, and a first coil disposed to face the first magnet.

According to an embodiment, the lens assembly may be disposed to move based on the housing. The camera module may further include a second driving unit for moving the lens assembly based on the housing in a second direction different from the first direction, or a third direction different from the first direction and the second direction.

As set forth above, an electronic device (e.g., the electronic device 300 of FIG. 5) according to an embodiment, may include a first plate, a second plate facing the first plate, a side member surrounding at least in part a space between the first plate and the second plate, and a camera module disposed inside the space. The camera module (e.g., the camera module 200 of FIG. 4) may include a housing (e.g., the housing 220 of FIG. 4), a lens assembly (e.g., the lens assembly 210 of FIG. 4) disposed at least in part inside the housing, and including at least one lens, an image sensor (e.g., the image sensor 260 of FIG. 4) for converting light received through the at least one lens into an electrical signal, a printed circuit board (e.g., the printed circuit board 250 of FIG. 4) including a first surface on which the housing is disposed, a base (e.g., the base 240 of FIG. 4) on which the printed circuit board is disposed, and at least one electrical element (e.g., the electrical element 290 of FIG. 4) connected to the printed circuit board. The printed circuit board may include a first region (e.g., the first region 250A of FIG. 4) having a thickness of a first length from the first surface in a first direction from the second plate to the first plate, and a second region (e.g., the second region 250B of FIG. 4) having a thickness (e.g., the second thickness w2 of FIG. 6) of a second length which is greater than the first length (e.g., the first thickness w1 of FIG. 6) from the first surface in the first direction. The first region may include a second surface facing the first surface. The at least one electrical element may be disposed on the second surface.

According to an embodiment, the electrical element may be disposed to overlap with the first region in the first direction. The base may be disposed to overlap with the second region in the first direction.

According to an embodiment, the electrical element may have a thickness of a third length in the first direction. A sum of the first length and the third length may be smaller than or equal to a fourth length which is a length from the first surface of the printed circuit board to a reference plane on which the base is disposed in the first direction.

According to an embodiment, the at least one side of the printed circuit board facing a direction substantially perpendicular to the first direction may include at least one side of the first region facing a direction substantially perpendicular to the first direction.

According to embodiment, the at least one electrical element may be disposed to overlap with at least a part of the second region or the base in a direction substantially perpendicular to the first direction.

According to an embodiment, the printed circuit board may include a plurality of circuit layers at least in part overlapping each other in the first direction. The number of circuit layers disposed in the first region may be smaller than the number of circuit layers disposed in the second region.

According to an embodiment, the electronic device may include at least one of at least one first solder disposed to bond the at least one electrical element to the first region, or at least one second solder disposed to bond the base to the second region.

According to an embodiment, the electronic device may include at least one adhesive member disposed between the second region and the base. The adhesive member may include at least one of an adhesive tape, a bond, or an epoxy.

According to an embodiment, the lens assembly may be disposed to move based on the housing. The camera module may further include a first driving unit disposed inside the housing, and moving the lens assembly in the first direction based on the housing. The first driving unit may include a first carrier for carrying the lens assembly in the first direction, and at least one first sphere disposed between the first carrier and the housing and disposed to move the first carrier in the first direction with respect to the housing. The first carrier may include at least one first guide portion for guiding the at least one first sphere to move in the first direction.

As set forth above, a camera module (e.g., the camera module 200 of FIG. 2) according to an embodiment, may include a housing (e.g., the housing 220 of FIG. 4), a lens assembly (e.g., the lens assembly 210 of FIG. 4) disposed at least in part inside the housing, and including at least one lens, an image sensor (e.g., the image sensor 260 of FIG. 4) for converting light received through the at least one lens into an electrical signal, a printed circuit board (e.g., the printed circuit board 250 of FIG. 4) including a first side (e.g., the first side 251 of FIG. 4) on which the lens assembly is disposed, a base (e.g., the base 240 of FIG. 4) on which the printed circuit board is disposed, and an electrical element (e.g., the electrical element 290 of FIG. 4) connected to the printed circuit board. The printed circuit board may include a first region (e.g., the first region 250A of FIG. 4) having a first thickness (e.g., the first thickness w1 of FIG. 6), and a second region (e.g., the second region 250B of FIG. 4) having a second thickness (e.g., the second thickness w2 of FIG. 6) which is greater than the first thickness. The first region may include a second side facing in a direction opposite to the first side. The electrical element may be disposed on the second side of the first region.

According to an embodiment, a part of the electrical element may be disposed to overlap with a part of the image sensor in a direction perpendicular to an optical axis of the camera module.

According to an embodiment, the lens assembly may have a reference position, and a distance between the lens assembly of the reference position and the printed circuit board may be smaller than a thickness of the electrical element.

According to an embodiment, the electrical element may include a plurality of chips disposed on the second side of the printed circuit board.

According to an embodiment, the electrical element may be disposed not to overlap with the base, but to overlap with the first region in a first direction corresponding to the optical axis of the camera module. The base may be disposed to overlap with the second region in the first direction.

According to an embodiment, the electrical element may have a third thickness. A sum of the first thickness and the third thickness may be smaller than or equal to a fourth thickness corresponding to a sum of the thickness of the base and the thickness of the second region of the printed circuit board.

According to an embodiment, the electrical element may be disposed to overlap with at least a part of at least one of the second region or the bases in a direction substantially perpendicular to the first direction.

According to an embodiment, the camera module may include at least one of at least one first solder disposed to bond the electrical element to the first region, or at least one second solder disposed to bond the base to the second region.

As set forth above, an electronic device according to an embodiment, may include a first plate, a second plate facing the first plate, a side member surrounding at least in part a space between the first plate and the second plate, and a camera module disposed inside the space. The camera module may include a housing, a lens assembly disposed at least in part inside the housing, and including at least one lens, an image sensor for converting light received through the at least one lens into an electrical signal, a printed circuit board including a first side on which the lens assembly is disposed, a base on which the printed circuit board is disposed, and an electrical element connected to the printed circuit board. The printed circuit board may include a first region having a first thickness, and a second region having a second thickness which is greater than the first thickness. The first region may include a second side facing in a direction opposite to the first side. The electrical element may be disposed on the second side of the first region.

According to an embodiment, a part of the electrical element may be disposed to overlap with a part of the image sensor in a direction perpendicular to an optical axis of the camera module.

According to an embodiment, the lens assembly may have a reference position, and a distance between the lens assembly of the reference position and the printed circuit board may be smaller than a thickness of the electrical element.

According to an embodiment, the electrical element may include a plurality of chips disposed on the second side of the printed circuit board.

According to an embodiment, the electrical element may be disposed not to overlap with the base, but to overlap with the first region in a first direction corresponding to the optical axis of the camera module. The base may be disposed to overlap with the second region in the first direction.

According to an embodiment, the electrical element may have a third thickness. A sum of the first thickness and the third thickness may be smaller than or equal to a fourth thickness corresponding to a sum of the thickness of the base and the thickness of the second region of the printed circuit board.

According to an embodiment, the electrical element may be disposed to overlap with at least a part of at least one of the second region or the bases in a direction substantially perpendicular to the first direction corresponding to the optical axis of the camera module.

In accordance with a first example, a camera module comprises a housing; a lens assembly at least partially disposed in the housing, and including at least one lens; an image sensor for converting light received through the at least one lens into an electrical signal; a printed circuit board including a first side at which the lens assembly is disposed; a base on which the printed circuit board is disposed; and an electrical element connected to the printed circuit board, wherein the printed circuit board includes a first region having a first thickness, and a second region having a second thickness greater than the first thickness, wherein the first region includes a second side opposite to the first side, and wherein the electrical element is disposed to (e.g., disposed on) the second side of the first region.

In a second example in accordance with the camera module of first example, a portion of the electrical element is disposed to overlap a portion (e.g., a part) of the image sensor in a direction perpendicular to an optical axis of the camera module.

In a third example in accordance with the camera module of the first example, lens assembly has a reference position, and a distance between the lens assembly at reference position and the printed circuit board is less (e.g., smaller than) than a thickness of the electrical element. For example, the reference position may be based on a central position of a movement range of the lens assembly (e.g., in a first direction corresponding to the optical axis, or, along the optical axis) of the camera module.

In a fourth example in accordance with the camera module of the first example, the electrical element comprises a plurality of chips disposed on the second side of the printed circuit board.

In fifth example in accordance with the camera module of the first example, the electrical element is disposed to overlap the first region without overlapping the base in a first direction corresponding to the optical axis of the camera module, and wherein the base is disposed to overlap the second region in the first direction. For example, the electrical element is disposed not to overlap with the base, but to overlap with the first region in a first direction corresponding to the optical axis of the camera module.

In a sixth example in accordance with the camera module of the fifth example, the electrical element has a third thickness in the first direction, and wherein a sum of the first thickness and the third thickness is less than or equal to a fourth thickness, wherein the fourth thickness corresponds to a sum of the thickness of the base and the second thickness of the second region of the printed circuit board.

In a seventh example in accordance with the camera module of the first example, at least one side (e.g., an edge) of the printed circuit board facing a direction substantially perpendicular to the first direction (e.g., a first direction corresponding to the optical axis of the camera module) includes at least one side of the first region facing the direction substantially perpendicular to the first direction (e.g., corresponding to the optical axis of the camera module).

In an eighth example in accordance with the camera module of the first example, the electrical element is disposed to overlap at least a portion of at least one of the second region or the base in a direction substantially perpendicular to the first direction.

In the ninth example in accordance with the camera module of the first example, the printed circuit board includes a plurality of circuit layers that at least partially overlap each other in the first direction, and a number of circuit layers disposed in the first region is smaller than a number of circuit layers disposed in the second region.

In an tenth example in accordance with the camera module of the first example, at least one of at least one first solder (e.g., a solder join, a solder fixture) is disposed to attach the electrical element to the first region, or at least one second solder is disposed to attach the base to the second region.

In an eleventh example in accordance with the camera module of the first example, at least one adhesive member is disposed between the second region and the base, wherein the at least one adhesive member includes at least one of an adhesive tape, a bond or an epoxy.

In accordance with a twelfth example, an electronic device comprises: a first plate; a second plate facing the first plate; a side member surrounding at least in part a space between the first plate and the second plate; and a camera module disposed inside the space, wherein the camera module comprises: a housing; a lens assembly disposed at least in part inside the housing, and comprising at least one lens; an image sensor for converting light received through the at least one lens into an electrical signal; a printed circuit board comprising a first side on which the lens assembly is disposed; a base on which the printed circuit board is disposed; and an electrical element connected to the printed circuit board, wherein the printed circuit board comprises a first region having a first thickness, and a second region having a second thickness which is greater than the first thickness, the first region comprises a second side facing in a direction opposite to the first side, and the electrical element is disposed to the second side of the first region.

In a thirteenth example in accordance with the electronic device of the twelfth example, a part of the electrical element is disposed to overlap with a part of the image sensor in a direction perpendicular to an optical axis of the camera module.

In a fourteenth example in accordance with the electronic device of the twelfth example, the lens assembly has a reference position, and a distance between the lens assembly of the reference position and the printed circuit board is smaller than a thickness of the electrical element.

In a fifteenth example in accordance with the electronic device of the twelfth example, the electrical element comprises a plurality of chips disposed on the second side of the printed circuit board.

In a sixteenth example in accordance with the electronic device of the twelfth example, the electrical element is disposed not to overlap with the base, but to overlap with the first region in a first direction corresponding to the optical axis of the camera module, and the base is disposed to overlap with the second region in the first direction.

In a seventeenth example in accordance with the electronic device of the sixteenth example, the electrical element has a third thickness, and a sum of the first thickness and the third thickness is smaller than or equal to a fourth thickness corresponding to a sum of the thickness of the base and the thickness of the second region of the printed circuit board.

In an eighteenth example in accordance with the electronic device of the twelfth example, at least one side of the printed circuit board facing in a direction substantially perpendicular to the first direction corresponding to the optical axis of the camera module comprises at least one side facing in a direction substantially perpendicular to the first direction of the first region.

In a nineteenth example in accordance with the electronic device of the twelfth example, the electrical element is disposed to overlap with at least a part of at least one of the second region or the bases in a direction substantially perpendicular to the first direction corresponding to the optical axis of the camera module.

In a twentieth example in accordance with the electronic device of the twelfth example, the printed circuit board comprises a plurality of circuit layers at least in part overlapping each other in a first direction corresponding to the optical axis of the camera module, and the number of circuit layers disposed in the first region is smaller than the number of circuit layers disposed in the second region.

Effects obtainable from the disclosure are not limited to the above-mentioned effects, and other effects which are not mentioned may be clearly understood by those skilled in the art of the technical field which the disclosure belongs to.

## Claims

1. A camera module comprising:
a housing;
a lens assembly at least partially disposed in the housing, and including at least one lens;
an image sensor;
a printed circuit board including a first side at which the lens assembly is disposed;
a base on which the printed circuit board is disposed; and
an electrical element connected to the printed circuit board,
wherein the printed circuit board includes a first region having a first thickness, and a second region having a second thickness greater than the first thickness,
wherein the first region includes a second side opposite to the first side, and
wherein the electrical element is disposed to the second side of the first region.

2. The camera module of claim 1, wherein a portion of the electrical element is disposed to overlap a portion of the image sensor in a direction perpendicular to an optical axis of the camera module.

3. The camera module of claim 1 or 2, wherein the lens assembly has a reference position, based on a central position of a movement range of the lens assembly, and
wherein a distance between the lens assembly at the reference position and the printed circuit board is less than a thickness of the electrical element.

4. The camera module of any preceding claim, wherein the electrical element comprises a plurality of chips disposed on the second side of the printed circuit board.

5. The camera module of any preceding claim, wherein the electrical element is disposed to overlap the first region without overlapping the base in a first direction corresponding to the optical axis of the camera module, and
wherein the base is disposed to overlap the second region in the first direction.

6. The camera module of claim 5, wherein the electrical element has a third thickness in the first direction, and
wherein a sum of the first thickness and the third thickness is less than or equal to a fourth thickness, wherein the fourth thickness corresponds to a sum of the thickness of the base and the second thickness of the second region of the printed circuit board.

7. The camera module of claim 1, wherein at least one side of the printed circuit board faces a direction substantially perpendicular to a first direction corresponding to the optical axis of the camera module; and includes at least one side of the first region facing the direction substantially perpendicular to the first direction.

8. The camera module of claim 1, wherein the electrical element is disposed to overlap at least a portion of at least one of the second region or the bases in a direction substantially perpendicular to a first direction corresponding to the optical axis of the camera module.

9. The camera module of any preceding claim, wherein the printed circuit board includes a plurality of circuit layers that at least partially overlap each other, and
a number of circuit layers disposed in the first region is smaller than a number of circuit layers disposed in the second region.

10. The camera module of any of claims 1 to 9, further comprising:
at least one adhesive member disposed between the second region and the base,
wherein the at least one adhesive member includes at least one of an adhesive tape, a bond or an epoxy.

11. The camera module of any preceding claim, further comprising:
a cover covering at least a part of a side surface of the housing and a top surface of the housing to form a space; and
wherein at least part of the lens assembly is disposed within the formed space.

12. The camera module of any preceding claim, further comprising:
a first driving unit, configured to move the lens assembly in a first direction; and
a second driving unit, configured to move the lens assembly in at least one of a second direction or third direction, the second and third directions being substantially perpendicular to the first direction.

13. An electronic device comprising:
a first plate;
a second plate facing the first plate;
a side member surrounding at least in part a space between the first plate and the second plate; and
a camera module in accordance with any of claims 1-12 disposed inside the space.

14. The electronic device of claim 13,
wherein the camera module is accommodated with the base facing the first plate and the at least one lens of the lens assembly facing the second plate.

15. The electronic device of any of claims 13 or 14, wherein the first region is spaced apart from the first plate by a first distance; and
wherein the second region is spaced apart from the first plate by a second distance;
wherein the first distance is greater than the second distance.
